# EUROPÄISCHE PATENTSCHRIFT

(11) **EP 3 177 114 B1**
(45) Veröffentlichungstag und Bekanntmachung des Hinweises auf die Patenterteilung: **28.10.2020**
(21) Anmeldenummer: 16200500.3
(22) Anmeldetag: 24.11.2016
(51) Int. Cl.: H05G 1/02

(54) **VERFAHREN ZUR JUSTAGE DER PRIMÄRSEITE EINES RÖNTGENDIFFRAKTOMETERS**
METHOD FOR ADJUSTING THE PRIMARY SIDE OF AN X-RAY DIFFRACTOMETER
PROCÉDÉ D'AJUSTEMENT DE LA FACE PRIMAIRE D'UN DIFFRACTOMÈTRE À RAYONS X

(30) Priorität: 03.12.2015 DE 102015224143
(43) Veröffentlichungstag der Anmeldung: 07.06.2017
(73) Patentinhaber: Incoatec GmbH, 21502 Geesthacht (DE)
(72) Erfinder: Kleine, Andreas, 22767 Hamburg (DE); Bashiry, Nima, 22143 Hamburg (DE); Bahr, Detlef, 76149 Karlsruhe (DE); Michaelsen, Carsten, 21380 Artlenburg (DE)
(74) Vertreter: Kohler Schmid Möbus Patentanwälte

(56) Entgegenhaltungen:
- EP-A1- 1 925 932
- DE-T5-112013 002 039
- US-A- 5 541 856
- US-A- 5 896 200
- US-A1- 2014 023 180

## Beschreibung

Die Erfindung betrifft ein Verfahren zur Justage der Primärseite eines Röntgendiffraktometers, wobei die Primärseite einen Kollimator, eine Röntgenoptik und eine Röntgenquelle, insbesondere eine Röntgenröhre, umfasst,
wobei der Kollimator, die Röntgenoptik und die Röntgenquelle direkt oder indirekt an einer Grundstruktur befestigt sind,
und wobei die Orientierung und Position der Röntgenoptik und die Position der Röntgenquelle relativ zur Grundstruktur verstellt werden.

Ein solches Verfahren wird beispielsweise bei der aus der EP 1 462 794 B1 bekannten Hochfluss-Röntgenquelle angewandt.

Ein weiteres Beispiel wird in EP 1 925 932 A1 offenbart.

Röntgendiffraktometrie ist ein leistungsfähiges Verfahren der instrumentellen Analytik, das zur Strukturaufklärung insbesondere von einkristallinen Proben eingesetzt werden kann.

Einkristalline Proben stehen oft nur in sehr kleiner Größe zur Verfügung; Probendurchmesser von 100 µm oder weniger sind häufig anzutreffen. Um eine solch kleine Probe vermessen zu können, ist eine sehr genaue Konditionierung und Justage des eingesetzten Röntgenstrahls erforderlich.

Röntgenstrahlen für die Einkristalldiffraktometrie werden typischerweise durch eine Röntgenröhre erzeugt, deren Quellfokus mit einer Röntgenoptik, etwa einem Montel-Spiegel, abgebildet wird. Der durch die Röntgenoptik konditionierte Strahl wird durch einen Kollimator auf die Probe gerichtet. Die gebeugte Röntgenstrahlung wird typischerweise mit einer CCD-Kamera erfasst. Die Probe wird mittels eines Goniometers ausgerichtet.

Bei einem solchen Röntgendiffraktometeraufbau ist die Justage der Primärseite, das sind die Komponenten vor der Probe, schwierig und zeitaufwändig, und wird in der Regel nur durch besonders geschultes Personal des Diffraktometerherstellers durchgeführt. Hierbei erfolgt eine relative Justage der Komponenten im Wesentlichen dadurch, dass eine ausgangsseitige Strahlintensität in einer Vielzahl von Einzelverstellschritten maximiert wird. Aufgrund von geltenden Sicherheitsvorschriften dürfen die Einzelverstellschritte nur bei unterbrochenem Röntgenstrahl erfolgen bzw. die Intensitätsmessungen nur bei geschlossenem Sicherheitsgehäuse erfolgen, was den Justageaufwand besonders erhöht. Besonders problematisch ist die Justage, wenn bei Justagebeginn aufgrund großer Fehlorientierung keine Röntgenintensität den Kollimator passiert. Da sehr viele Freiheitsgrade bestehen, ist unklar, welche Verstellpositionen in welcher Weise geändert werden müssen, um wieder Intensität zu finden. Oft dauert die Justage der Primärseite eines Röntgendiffraktometers mehrere Tage.

Aus der EP 1 462 794 B1 ist eine Hochfluss-Röntgenquelle bekannt geworden, bei der an einer Röntgenröhre eine Röntgenoptik in einem Gehäuse montiert ist, wobei zur Justage das Gehäuse gegenüber der Röntgenröhre mittels vier Verstellschrauben verkippt und verschoben werden kann. An der Röntgenröhre ist weiterhin ein Kollimator montiert, der zur Justage mittels zweier Stellschrauben verkippt werden kann. Die Röntgenröhre wiederum kann gegenüber einem Standfuß mittel fünf Schrauben vertikal und horizontal verstellt werden.

Aus der DE 11 2013 002 039 T5 ist ein Röntgenanalysator bekannt geworden, bei dem die Position eines primärstrahlseitigen Mehrschichtspiegels mittels eines Motors justiert werden kann. Weiterhin werden Sensoren zum Detektieren der Position von optischen Röntgenkomponenten vorgeschlagen.

Die EP 1 365 231 A2 beschreibt ein Röntgendiffraktometer, wobei eine Röntgenquelle und ein Monochromator fest zueinander vormontiert sind.

### Aufgabe der vorliegenden Erfindung

Es ist die Aufgabe der vorliegenden Erfindung, die Justage der Primärseite eines Röntgendiffraktometers zu beschleunigen und zu vereinfachen.

### Kurze Beschreibung der Erfindung

Diese Aufgabe wird gelöst durch ein Verfahren nach Anspruch 1.

Die vorliegende Erfindung schlägt vor, die Justage der Primärseite eines Röntgendiffraktometers, insbesondere Einkristall-Röntgendiffraktometers, dadurch zu erleichtern, dass die Position der Röntgenquelle und die Position und die Orientierung der Röntgenoptik initial nicht iterativ anhand von Röntgen-Einzelmessschritten relativ zueinander eingestellt werden. Vielmehr wird mit den Bauelementen unmittelbar eine jeweilige vordefinierte Einstellung relativ zur Grundstruktur (auch Grundkörper genannt), auf der diese Bauelemente befestigt sind, aufgesucht. Zu diesem Zwecke erfolgt eine Messung der Position der Röntgenquelle und der Position und Orientierung der Röntgenoptik relativ zur Grundstruktur, gegebenenfalls auch mehrfach, und die Bauelemente werden verstellt, bis die jeweiligen Sollwerte erreicht sind. Dadurch ist automatisch dann auch eine passende relative Orientierung der Bauelemente untereinander gegeben.

Für die Einstellung sind im Rahmen der Erfindung keine Röntgenmessungen am zu justierenden Diffraktometer erforderlich. Die Vermessung der Position bzw. Orientierung der Bauelemente relativ zur Grundstruktur kann im Rahmen der Erfindung grundsätzlich bei offenem Röntgen-Sicherheitsgehäuse erfolgen, insbesondere mechanisch oder optisch. Die Verstellung der Bauelemente kann während der laufenden Vermessung der Position bzw. Orientierung erfolgen, falls gewünscht. Die Einstellung auf die Sollwerte kann daher insgesamt sehr schnell erfolgen.

Die erfindungsgemäße Vermessung der Position bzw. Orientierung eines Bauelements (Röntgenoptik, Röntgenquelle, ggf. Kollimator bzw. Kollimatoröffnung) relativ zur Grundstruktur erfolgt indirekt gegenüber einem Hilfskörper, der in definierter (bekannter) Weise ausgebildet ist und in definierter (bekannter) Weise zur Grundstruktur positioniert ist. Bevorzugt wird der Hilfskörper lediglich zeitweilig an der Grundstruktur angeordnet bzw. befestigt ("Referenzkörper"); dieser stellt dann eine temporäre Verlängerung der Grundstruktur dar.

In der Regel wird nach Einstellung der Sollwerte bereits hinter dem Kollimator wenigstens 10% der maximalen Strahlintensität, die mit dem Röntgendiffraktometer (nach vollständiger Justage) erreichbar ist, erreicht. Die vorgegebenen Sollwerte können vorab für den Diffraktometertyp einmalig experimentell bestimmt werden oder auch berechnet werden. Nachdem die vorgegebenen Sollwerte eingestellt sind, schließen sich typischerweise Feinjustageschritte an, um die Röntgenstrahlintensität und ggf. die Röntgenstrahlposition zu optimieren.

Typischerweise wird eine Position im Rahmen der Erfindung in einer Richtung (Strichfokussysteme, senkrecht zur Strichrichtung und zur Strahlausbreitungsrichtung) oder zwei Richtungen (Punktfokussysteme), die jeweils senkrecht zur Strahlausbreitungsrichtung (z) verlaufen, vermessen. Falls gewünscht, kann auch zusätzlich in Strahlausbreitungsrichtung (z) vermessen werden; allerdings können die Bauelemente in diese Richtung (z) in der Regel durch Anschläge ausreichend genau positioniert werden. Eine Orientierung wird im Rahmen der Erfindung typischerweise entlang einer Achse (Strichfokussysteme, parallel zur Strichrichtung) oder zwei Achsen (Punktfokussysteme), die senkrecht zur Strahlausbreitungsrichtung (z) verlaufen, vermessen.

Die Position und Orientierung der Röntgenoptik kann im Rahmen der Erfindung verstellt werden, indem die Röntgenoptik innerhalb eines Gehäuses verstellt wird, oder indem ein Gehäuse, das die Röntgenoptik enthält, verstellt wird, oder eine Kombination aus beidem. Die Position der Röntgenquelle wird typischerweise verstellt, indem die Röntgenquelle (also das RöntgenquellenBauteil, etwa eine Röntgenröhre) einschließlich eines etwaigen Gehäuses (typischerweise tragend ein Kühlsystem und/oder einen Shutter), verstellt wird, in der Regel wobei die Röntgenquelle ortsfest im Gehäuse angeordnet ist. Alternativ ist es auch möglich, die Röntgenquelle innerhalb ihres Gehäuses zu verstellen, in der Regel wobei das Gehäuse ortsfest an der Grundstruktur angeordnet ist. Auch hier ist eine Kombination aus Verstellung des Gehäuses auf der Grundstruktur und der Röntgenquelle im Gehäuse denkbar.

Vorteilhafter Weise sind die Bauelemente (Röntgenoptik, Röntgenquelle und bevorzugt auch der Kollimator) einzeln (voneinander unabhängig) und reversibel an der Grundstruktur befestigt. Bei einem Austausch eines der Bauelemente (insbesondere der Röntgenröhre) brauchen das oder die anderen Bauelemente (insbesondere die Röntgenoptik) dann nicht verändert zu werden. Dies erleichtert die Rejustage bei Reinstallation des ausgetauschten Bauelements. In der Regel genügt es, bei der Reinstallation für das ausgetauschte Bauelement die letzte Position bzw. Orientierung vor dem Austausch wieder aufzusuchen, evtl. gefolgt von einer Feinjustage nur dieses Bauelements.

### Bevorzugte Varianten der Erfindung

Bei einer bevorzugten Variante des erfindungsgemäßen Verfahrens werden die Orientierung der Röntgenoptik mit einer Genauigkeit von 1 mrad oder besser und die Positionen der Röntgenoptik und der Röntgenquelle mit einer Genauigkeit von 50 µm oder besser, bevorzugt 20 µm oder besser, vermessen und eingestellt. Dadurch kann eine weitgehende Justage des Röntgendiffraktometers noch ohne Röntgenstrahl erfolgen. Die angegebenen Genauigkeiten eignen sich insbesondere für den Fall, dass die Röntgenoptik mit einem Montelspiegel und die Röntgenquelle mit einer Mikrofokusquelle ausgebildet ist. Falls auch die Position des Kollimators vermessen und auf einen vorgegebenen Sollwert eingestellt wird, wird bevorzugt auch diese mit einer Genauigkeit von 50 µm oder besser, insbesondere 20 µm oder besser, vermessen und eingestellt.

Besonders bevorzugt ist eine Variante, bei der
- die Orientierung und Position der Röntgenoptik relativ zur Grundstruktur und
- die Position der Röntgenquelle relativ zur Grundstruktur unabhängig voneinander eingestellt werden. Dadurch wird ein Aufaddieren von Einstellungsfehlern der beiden Bauelemente verhindert, und die vorgegebenen Sollwerte können besonders schnell und in beliebiger Reihenfolge eingestellt werden.

Vorteilhaft ist auch eine Variante, bei der die Position der Röntgenquelle sowie die Position und Orientierung der Röntgenoptik durch Abstandsmessungen vermessen werden. Abstandsmessungen sind vergleichsweise einfach durchzuführen. Die Abstandsmessungen können beispielsweise durch mechanisches Abtasten oder auch eine Laserentfernungsmessung erfolgen. Falls auch die Position des Kollimators vermessen wird, erfolgt dies bevorzugt auch durch Abstandsmessungen.

Bei einer bevorzugten Verfahrensvariante ist vorgesehen, dass die Position und Orientierung der Röntgenoptik verstellt wird, indem die Position und die Orientierung eines Gehäuse der Röntgenoptik, in dem die Röntgenoptik in bekannter Weise angeordnet ist, insbesondere fest angeordnet ist, verstellt wird, und dass zur Bestimmung der Position und Orientierung der Röntgenoptik die Position und Orientierung des Gehäuses der Röntgenoptik vermessen wird. Durch das Gehäuse wird die Röntgenoptik geschützt, insbesondere mechanisch, und durch ein Vakuum oder eine He-Atmosphäre im Gehäuse kann eine Reaktion mit Luftsauerstoff verhindert werden. Vakuum oder eine He-Atmosphäre verhindern zudem eine Luftabsorption der Röntgenstrahlung, wodurch die Performance des Diffraktometers verbessert wird. Die Vermessung des Gehäuses ist vergleichsweise einfach von außen möglich; über die bekannte relative Lage der Röntgenoptik im Gehäuse kann dann die Lage der Röntgenoptik relativ zur Grundstruktur bestimmt (berechnet) werden. Für diese Variante wird vorab die Position und Orientierung der Röntgenoptik relativ zum Gehäuse bestimmt und/oder eingestellt, etwa durch eine geeignete Messung oder ein hinreichend präzises Herstellungsverfahren.

Bei einer anderen, vorteilhaften Verfahrensvariante ist vorgesehen, dass die Röntgenoptik in einem Gehäuse angeordnet ist, das zumindest teilweise aus optisch transparentem Material gefertigt ist, und dass die Vermessung der Position und der Orientierung der Röntgenoptik durch das optisch transparente Material hindurch erfolgt, insbesondere mittels Laserentfernungsmessung, insbesondere wobei die Position und die Orientierung der Röntgenoptik im Gehäuse der Röntgenoptik verstellt wird. Durch das Gehäuse wird die Röntgenoptik geschützt, insbesondere mechanisch, und durch ein Vakuum oder eine He-Atmosphäre im Gehäuse kann eine Reaktion mit Luftsauerstoff verhindert werden. Vakuum oder eine He-Atmosphäre verhindern zudem eine Luftabsorption der Röntgenstrahlung, wodurch die Performance des Diffraktometers verbessert wird. Die direkte Vermessung der Röntgenoptik durch das Gehäuse hindurch ist besonders präzise, und benötigt insbesondere keine Umrechnung von einer Gehäuselage in eine Röntgenoptiklage. Eine Verstellung der Röntgenoptik im Gehäuse kann erfasst und berücksichtigt werden. Alternativ oder zusätzlich kann auch eine Verstellung der Position und Orientierung der Röntgenoptik über das Gehäuse der Röntgenoptik vorgesehen sein.

Bevorzugt ist auch eine Verfahrensvariante, die vorsieht,
dass die Position der Röntgenquelle in zwei linear unabhängige Richtungen (x, y) senkrecht zur Strahlausbreitungsrichtung (z) relativ zur Grundstruktur verstellt wird,
insbesondere wobei die Position der Röntgenquelle durch zwei Abstandsmessungen vermessen wird,
und dass die Position der Röntgenoptik in zwei linear unabhängigen Richtungen (x, y) senkrecht zur Strahlausbreitungsrichtung (z) und die Orientierung der Röntgenoptik bezüglich zweier Achsen (A, B) senkrecht zur Strahlausbreitungsrichtung (z) relativ zur Grundstruktur verstellt wird, insbesondere wobei die Position und Orientierung der Röntgenoptik durch vier Abstandsmessungen vermessen wird. Dieses Vorgehen hat sich in der Praxis bewährt, insbesondere für Punktfokusquellen. Die Abstandsmessungen sind besonders einfach durchzuführen.

Besonders bevorzugt ist eine Variante, bei der weiterhin die Position wenigstens einer Kollimatoröffnung des Kollimators relativ zur Grundstruktur vermessen und auf einen vorgegebenen Sollwert eingestellt wird, so dass bei den eingestellten Sollwerten ausgangsseitig des Kollimators von der Röntgenquelle ausgehende und durch die Röntgenoptik konditionierte Röntgenstrahlung nachweisbar ist. Durch Einbeziehung eines verstellbaren Kollimators in die erfindungsgemäße Vermessung und Einstellung der Bauelemente auf Sollwerte kann eine initiale Fehlpositionierung des Kollimators bzw. der wenigstens einen Kollimatoröffnung verhindert bzw. minimiert werden, so dass die Justage der Primärseite insgesamt noch schneller erfolgen kann. Der Kollimator kann im einfachsten Fall mit nur einer Kollimatoröffnung ("1-Lochblenden-Kollimator") ausgebildet sein; diese wird dann vermessen und auf einen Sollwert eingestellt, etwa über das Strahlrohr des Kollimators. Ebenso ist es möglich, einen Kollimator mit zwei Kollimatoröffnungen ("2-Lochblenden-Kollimator") einzusetzen; hierbei kann beispielsweise eine Kollimatoröffnung vermessen und auf einen Sollwert eingestellt werden, etwa über das Strahlrohr, und die andere Kollimatoröffnung nur verstellbar (nicht aber vermessbar) sein, wobei die andere Kollimatoröffnung zu Beginn dann meist auf eine näherungsweise mittige Position eingestellt wird; es ist allerdings auch möglich, beide Kollimatoröffnungen zu vermessen und auf Sollwerte einzustellen. Letzterem Fall entspricht auch eine Vermessung und Einstellung der Position und Orientierung eines Kollimatorbauteils mit zwei fest an diesem angeordneten Kollimatoröffnungen. Alternativ zu dieser Variante ist es auch möglich, einen nicht verstellbaren, insbesondere fest angeordneten Kollimator einzusetzen, bevorzugt wobei der Kollimator direkt an der Grundstruktur angeordnet ist.

Vorteilhafter Weise wird die Position der wenigstens einen Kollimatoröffnung des Kollimators relativ zur Grundstruktur unabhängig von der Position der Röntgenquelle und der Position und Orientierung der Röntgenoptik eingestellt. Dadurch wird wiederum ein Aufaddieren von Einstellungsfehlern verhindert, und die vorgegebenen Sollwerte können besonders schnell und in beliebiger Reihenfolge eingestellt werden.

Bei einer vorteilhaften Verfahrensvariante ist vorgesehen, dass nach Einstellung der vorgegebenen Sollwerte eine Feineinstellung der Position der Röntgenquelle erfolgt, bei der eine Strahlintensität ausgangsseitig der Röntgenoptik maximiert wird, insbesondere wobei für diese Feineinstellung der Position der Röntgenquelle der Kollimator aus dem Strahlengang des Röntgendiffraktometers entfernt wird. Diese iterative Feineinstellung mit Röntgenstrahl ist besonders einfach, da sie lediglich einen oder zwei Verstellparameter betrifft. Mit ihr können insbesondere Abweichungen der Quellfokusposition in der Röntgenquelle (im Röntgenquellenbauteil, etwa in der Röntgenröhre) von der idealen Position verursacht durch Bauteiltoleranzen ausgeglichen werden.

Besonders bevorzugt ist eine Verfahrensvariante, bei der nach Einstellung der vorgegebenen Sollwerte und ggf. Feineinstellung der Position der Röntgenquelle eine gemeinsame Feineinstellung der Position der Röntgenquelle und der Position der Röntgenoptik erfolgt, bei der eine Strahlintensität ausgangsseitig des Kollimators maximiert wird, wobei zwischen Intensitätsmessungen die Röntgenoptik und die Röntgenquelle jeweils um gleiche Strecken in gleiche Richtungen verfahren werden. Auch diese iterative, gemeinsame Feineinstellung am Röntgenstrahl ist besonders einfach, da sie effektiv lediglich einen oder zwei Freiheitsgrade betrifft. Mit ihr können insbesondere durch Bauteiltoleranzen verursachte Fehler der Strahlposition relativ zum Kollimator ausgeglichen werden. Nach der gemeinsamen Feineinstellung kann sich eine (weitere) Feineinstellung der Position der Röntgenquelle zur Intensitätsmaximierung hinter dem Kollimator anschließen; hierbei wird die Strahlposition ausgangsseitig der Röntgenoptik nicht mehr verändert. Für die gemeinsame Feineinstellung kann der Kollimator aus dem Strahlengang des Röntgendiffraktometers entfernt werden, insbesondere wobei anstelle des Kollimators ein kalibrierter 2D-Detektor in den Strahlengang gebracht wird, und der Röntgenstrahl auf eine Sollposition auf dem 2D-Detektor eingestellt wird, die der Position der Kollimatoröffnung entspricht. Durch die Verwendung des 2D-Detektors kann im Ergebnis die Strahlintensität ausgangsseitig des Kollimators maximiert werden.

Vorteilhaft ist auch eine andere Verfahrensvariante, bei der nach Einstellung der vorgegebenen Sollwerte und ggf. Feineinstellung der Position der Röntgenquelle eine Feineinstellung der Position wenigstens einer Kollimatoröffnung des Kollimators erfolgt, bei der eine Strahlintensität ausgangsseitig des Kollimators maximiert wird. Diese iterative Feineinstellung mit Röntgenstrahl ist besonders einfach, da sie (je Kollimatoröffnung) lediglich einen oder zwei Verstellparameter betrifft. Mit dieser Feineinstellung können insbesondere durch Bauteiltoleranzen verursachte Abweichungen der Position der Kollimatoröffnung des Kollimators von der Idealposition bzw. relativ zur Strahlposition ausgeglichen werden. In dieser Variante braucht in der Regel keine anschließende Maximierung der Röntgenintensität durch Feineinstellung der Position der Röntgenquelle erfolgen.

Eine bevorzugte Verfahrensvariante sieht vor, dass vor dem Einstellen der vorgegebenen Sollwerte zunächst eine Position eines Quellfokus der Röntgenquelle relativ zu einem Gehäuse der Röntgenquelle bestimmt oder auf einen vorgegebenen Fokussollwert relativ zum Gehäuse eingestellt wird, und dass die Position der Röntgenquelle verstellt wird, indem die Position des Gehäuses der Röntgenquelle verstellt wird, und zur Bestimmung der Position der Röntgenquelle die Position des Gehäuses der Röntgenquelle vermessen wird. Durch dieses Vorgehen können Fehler aufgrund einer ungenauen Position des Quellfokus in der Röntgenquelle (im Röntgenquellenbauteil, etwa der Röntgenröhre), ausgeglichen werden. Die Position des Quellfokus wird bevorzugt mit einer Genauigkeit von 50 µm oder besser, besonders bevorzugt 20 µm oder besser, relativ zum Gehäuse bestimmt oder auf den Fokussollwert eingestellt; dies erfolgt bevorzugt, bevor die Röntgenquelle am Diffraktometer angeordnet wird, beispielsweise noch beim Röntgenröhrenhersteller. Alternativ kann auch direkt die Position des Quellfokus relativ zur Grundstruktur bestimmt und auf einen Fokussollwert relativ zur Grundstruktur durch Verfahren der Röntgenquelle, insbesondere im Gehäuse, eingestellt werden.

Vorteilhaft ist eine Verfahrensvariante, die vorsieht, dass nach vollständiger Justage der Primärseite die Orientierung und Position der Röntgenoptik und die Position der Röntgenquelle und ggf. auch die Position der wenigstens einen Kollimatoröffnung des Kollimators relativ zur Grundstruktur nochmals vermessen werden und die zughörigen Messdaten notiert werden, und dass nach einer Dejustage eines oder mehrerer Bauelemente, insbesondere durch ein Erdbeben oder eine andere äußere Erschütterung des Röntgendiffraktometers, die Bauelemente entsprechend der notierten Messdaten relativ zur Grundstruktur eingestellt werden. Durch dieses Vorgehen kann ein Röntgendiffraktometer nach insbesondere unbeabsichtigten Dejustagen schnell wieder betriebsbereit gemacht werden.

Bevorzugt ist auch eine Verfahrensvariante, bei der die Primärseite insgesamt auf eine Probe ausgerichtet wird, indem die Grundstruktur gegenüber einem Fußelement, das mit einem Goniometer verbunden ist, verfahren oder verschwenkt wird, insbesondere wobei das Fußelement starr mit dem Goniometer verbunden ist, und insbesondere wobei die Probe auf dem Goniometer angeordnet ist. Typischerweise ist die Grundstruktur mittels Verstellelementen, insbesondere Verstellschrauben, an Trägern gegenüber dem Fußelement verfahrbar oder verschwenkbar.

### Erfindungsgemäße Röntgendiffraktometer

In den Rahmen der vorliegenden Erfindung fällt auch ein Röntgendiffraktometer nach Anspruch 16.

Für die Einstellung der Bauelemente mittels der Messeinrichtung(en) ist kein Röntgenstrahl erforderlich. Die Messeinrichtung(en) arbeiten bevorzugt mechanisch oder optisch. Das Röntgendiffraktometer kann eine Vielzahl von fest angeordneten Messeinrichtungen für die gleichzeitige Erfassung aller Positions- und Orientierungsinformationen umfassen. Alternativ kann das Röntgendiffraktometer nur eine Messeinrichtung umfassen, die an unterschiedlichen Messstellen angeordnet werden kann, so dass zeitlich nacheinander alle Positions- und Orientierungsinformationen erfasst werden können. Ebenso ist eine Mischung von fest angeordneten und an verschiedenen Messstellen anordenbaren Messeinrichtungen möglich. Die Verstelleinrichtungen sind typischerweise Verstellschrauben.

Bei einer bevorzugten Ausführungsform des erfindungsgemäßen Röntgendiffraktometers weisen die eine oder die mehreren Messeinrichtungen eine Messgenauigkeit für die Orientierung der Röntgenoptik von 1 mrad oder besser und eine Messgenauigkeit für die Positionen der Röntgenoptik und der Röntgenquelle von 50 µm oder besser, bevorzugt 20 µm oder besser, auf. Dadurch kann eine weitgehende Justage des Röntgendiffraktometers noch ohne Röntgenstrahl erfolgen. Die angegebenen Genauigkeiten eignen sich insbesondere für den Fall, dass die Röntgenoptik mit einem Montelspiegel und die Röntgenquelle mit einer Mikrofokusquelle ausgebildet ist.

Eine bevorzugte Ausführungsform sieht vor, dass die eine oder die mehreren Messeinrichtungen ein mechanisches Abtastelement und/oder ein Laserentfernungsmesselement umfassen. Diese Typen von Messeinrichtung sind zuverlässig und einfach zu handhaben. Weiterhin können die eine oder die mehreren Messeinrichtungen ein induktives Entfernungsmesselement oder ein kapazitives Entfernungsmesselement umfassen.

Bevorzugt ist auch eine Ausführungsform, bei der die Röntgenoptik mit einem Montelspiegel oder einem Goebelspiegel ausgebildet ist. Mit diesen Röntgenoptiken ist eine Strahlkonditionierung in bis zu zwei Dimensionen auf einfache Weise möglich. Bevorzugt liegen Beschichtungsfehler (Abweichung der Multischichtperiode vom idealen Wert) bei 3 % oder weniger, bevorzugt 1% oder weniger, besonders bevorzugt bei 0,2% oder weniger. Bei entsprechenden Beschichtungsfehlern bleibt ein resultierender Winkelfehler des reflektierten Röntgenstrahls in der Größenordnung der typischen Reflexbreite (oder darunter). Weiterhin bevorzugt liegen Formfehler bei 20 Winkelsekunden r.m.s. oder weniger, bevorzugt 10 Winkelsekunden r.m.s. oder weniger, besonders bevorzugt bei 1 Winkelsekunde r.m.s. oder weniger. Bei entsprechenden Formfehlern (Tangentenfehlern) bleibt ein Formfehlerbeitrag der Position des Probenfokus unter typischen Verhältnissen noch ca. um einen Faktor 5 (oder mehr) kleiner als der Probendurchmesser. Als Röntgenoptik ist auch eine Polykapillaroptik möglich.
Vorteilhafter Weise ist bei einer Ausführungsform die Röntgenquelle mit
- einer Mikrofokus-Röntgenröhre, insbesondere einer stationären Mikrofokus-Röntgenröhre,
- einer Drehanoden-Röntgenröhre oder
- einer Flüssigmetall-Röntgenröhre ausgebildet. Diese Röntgenquellen-Typen können im Rahmen der Erfindung durch die Messeinrichtung(en) gegenüber der Grundstruktur vorjustiert werden. Die Mikrofokus-Röntgenröhre ist typischerweise mit einem optischen Quellfokusdurchmesser von 50 µm oder kleiner ausgebildet.
Besonders bevorzugt ist eine Ausführungsform, bei der die eine oder die mehreren Messeinrichtungen an einem einzigen, einstückigen Bauteil angeordnet sind und/oder alle Messstellen für die eine oder die mehreren Messeinrichtungen an dem einzigen, einstückigen Bauteil ausgebildet sind. Dadurch wird ein Aufaddieren von Fehlern bei der Einstellung der Positionen und Orientierungen der Bauelemente relativ zueinander vermieden.

In der Ausführungsform der Erfindung ist vorgesehen, dass das Röntgendiffraktometer einen Referenzkörper umfasst, wobei der Referenzkörper reversibel an der Grundstruktur befestigt ist, und dass die eine oder die mehreren Messeinrichtungen an dem Referenzkörper angeordnet sind und/oder alle Messstellen für die eine oder die mehreren Messeinrichtungen an dem Referenzkörper ausgebildet sind. Der Referenzkörper kann gezielt während der Justage der Primärseite des Röntgendiffraktometers eingesetzt werden, und für den laufenden Messbetrieb wieder entfernt werden. Dadurch kann das Röntgendiffraktometer im laufenden Messbetrieb kompakt gehalten werden. Durch die Anordnung der Messeinrichtung(en) bzw. Messstellen am Referenzkörper wird ein Aufaddieren von Fehlern bei der Einstellung der Positionen und Orientierungen der Bauelemente relativ zueinander vermieden. Die Befestigung des Referenzkörpers sollte in den zu justierenden Richtungen auf 50 µm genau oder besser reproduzierbar sein. Der Referenzkörper ist bevorzugt als einziges einstückiges Bauteil (siehe oben) ausgebildet.

Eine bevorzugte Weiterbildung zu dieser Ausführungsform sieht vor, dass der Referenzkörper an einer in Strahlausbreitungsrichtung (z) verlaufenden Führung, insbesondere Nut, auf die Grundstruktur aufschiebbar und an der Grundstruktur arretierbar ist, insbesondere mittels Feststellschrauben,
und dass ein Anschlagelement, insbesondere am Referenzkörper oder an der Grundstruktur oder an einem Gehäuse der Röntgenoptik oder an einer Haltevorrichtung der Röntgenoptik, vorgesehen ist, mit dem eine definierte Position des Referenzkörpers auf der Führung aufgesucht werden kann. Mittels der Führung kann der Referenzkörper senkrecht zur Strahlausbreitungsrichtung (also bezüglich x, y) auf einfache Weise präzise an der Grundstruktur positioniert werden (bevorzugt auf 50 µm genau oder besser, besonders bevorzugt auf 20 µm genau oder besser), so dass die Vermessung der Bauelemente vom Referenzkörper aus zur Vermessung der relativen Positionen und Orientierungen zur Grundstruktur genutzt werden kann. Die Positionierung des Referenzkörpers in z-Richtung mit dem Anschlagelement ist im Allgemeinen hinreichend genau für die Konditionierung des Röntgenstrahls.

Der Anschlag kann insbesondere an einem Zwischenelement der Haltevorrichtung erfolgen.

Eine Weiterentwicklung zu dieser Weiterbildung sieht vor,
dass die Röntgenoptik mittels einer Haltevorrichtung an der Grundstruktur befestigt ist,
dass ein Basiselement der Haltevorrichtung entlang einer in Strahlausbreitungsrichtung (z) verlaufenden Basisführung, insbesondere Nut, der Grundstruktur verfahrbar und an der Grundstruktur arretierbar ist, insbesondere wobei ein Endanschlag und/oder eine Skala für das Basiselement ausgebildet ist,
dass ein Zwischenelement der Haltevorrichtung gegenüber dem Basiselement in zwei zueinander senkrechte Richtungen (x, y), die senkrecht zur Strahlausbreitungsrichtung (z) verlaufen, im Folgenden erste Richtung (x) und zweite Richtung (y) genannt, verstellbar ist,
dass die Röntgenoptik gegenüber dem Zwischenelement um zwei zueinander senkrechte Achsen (A, B), die senkrecht zur Strahlausbreitungsrichtung (z) verlaufen, verkippbar ist,
insbesondere wobei die Röntgenoptik von dem Zwischenelement umgriffen ist, und dass das Anschlagelement des Referenzkörpers entlang der ersten Richtung (x) auf das Zwischenelement zu ausfahrbar ist, wobei das Zwischenelement und das Anschlagelement gegenseitige Anschlagflächen parallel zur ersten und zweiten Richtung (x, y) ausbilden. Diese Bauform stellt die für die Positionierung und Orientierung der Röntgenoptik notwendigen Freiheitsgrade auf einfache Weise zur Verfügung. Das Anschlagelement kann an der Haltevorrichtung, insbesondere dem Zwischenelement, angelegt werden, um den Referenzkörper auszurichten. Durch Zurückziehen des ausfahrbaren Anschlagelements nach der z-Ausrichtung des Referenzkörpers kann ein Kraftübertrag auf die Haltevorrichtung durch Anziehen von Feststellschrauben oder dgl. bei der Fixierung des Referenzkörpers vermieden werden.

Bei einer vorteilhaften Ausführungsform des erfindungsgemäßen Röntgendiffraktometers weist das Röntgendiffraktometer ein Fußelement auf, wobei eine Position und/oder Orientierung der Grundstruktur gegenüber dem Fußelement verstellbar ist,
insbesondere wobei die Orientierung der Grundstruktur entlang zweier zueinander senkrechter Achsen, die senkrecht zur Strahlausbreitungsrichtung (z) verlaufen, verstellbar ist. Mittels der Verstellbarkeit der Grundstruktur gegenüber dem Fußelement ist die Primärseite bzw. der Röntgenstrahl auf die Probe auf einfache Weise ausrichtbar. Das Fußelement ist typischerweise starr mit einem Goniometer des Röntgendiffraktometers verbunden.

Besonders bevorzugt ist eine Ausführungsform, die vorsieht, dass der Kollimator, die Röntgenoptik und die Röntgenquelle unabhängig voneinander an der Grundstruktur befestigt sind, und dass für die Röntgenoptik und die Röntgenquelle jeweils eigene Verstelleinrichtungen vorgesehen sind, so dass
- die Orientierung und Position der Röntgenoptik relativ zur Grundstruktur
- und die Position der Röntgenquelle relativ zur Grundstruktur unabhängig voneinander eingestellt werden können. Typischerweise besitzt auch der Kollimator für eine oder mehrere Kollimatoröffnungen (Lochblenden) jeweils eine eigene Verstelleinrichtung zur unabhängigen Einstellung der jeweiligen Position relativ zur Grundstruktur. Durch diese Bauform wird ein Aufaddieren von Einstellungsfehlern verhindert, und die vorgegebenen Sollwerte können besonders schnell und in beliebiger Reihenfolge eingestellt werden.

Eine vorteilhafte Weiterbildung dieser Ausführungsform sieht vor, dass die Röntgenoptik und/oder die Röntgenquelle und/oder der Kollimator jeweils reversibel auf einer Zwischenhalterung befestigt sind, und dass jede Zwischenhalterung jeweils mittels einer eigenen Verstelleinrichtung gegenüber der Grundstruktur verstellbar ist,
insbesondere wobei die Zwischenhalterung oder die Zwischenhalterungen als Klemmhalterungen oder Magnethalterungen, bevorzugt Dreipunkt-Magnethalterungen, mit einer voreingestellten Klemmkraft oder Haltekraft ausgebildet sind. Mittels der Zwischenhalterungen ist es möglich, einzelne Bauelemente (etwa die Röntgenquelle bei Verschleiß) auszutauschen, ohne die Position und Orientierung des ausgetauschten Bauelements zu verändern. Position und Orientierung des ausgetauschten Bauelements wird durch die Einstellung der Zwischenhalterung bestimmt, die beim Austausch unverändert an der Grundstruktur verbleiben kann.

Vorteilhaft ist auch eine Ausführungsform, bei der die Verstelleinrichtungen zur Verstellung der Position der Röntgenquelle und zur Verstellung der Position der Röntgenoptik in einer jeweiligen Richtung als Verstellschrauben mit gleicher Ganghöhe ausgebildet sind. Dadurch ist es auf einfache Weise möglich, bei einer gemeinsamen Feinjustage von Röntgenquelle und Röntgenoptik jeweils bei beiden Bauelementen die Position um eine identische Strecke zu verstellen. Hierfür werden die beteiligten Verstellschrauben der beiden Bauelemente jeweils um den gleichen Winkel verstellt.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Übersicht über eine Ausführungsform eines Röntgendiffraktometers;
- Fig. 2: eine schematische Schrägansicht der Primärseite des Röntgendiffraktometers;
- Fig. 3: eine schematische Schrägansicht der Primärseite des Röntgendiffraktometers, mit Referenzkörper zur Justage von Röntgenoptik und Röntgenquelle;
- Fig. 4: eine schematische Schrägansicht der Primärseite des Röntgendiffraktometers, mit alternativem Referenzkörper zur Justage von Röntgenoptik, Röntgenquelle und Kollimator;
- Fig. 5: eine schematische Aufsicht auf die Primärseite des Röntgendiffraktometers von Fig. 3;
- Fig. 6: eine schematische Schrägansicht einer Haltevorrichtung für die Röntgenoptik des Röntgendiffraktometers;
- Fig. 7: eine schematische Frontalansicht auf die Haltevorrichtung von Fig. 6;
- Fig. 8: eine schematische Seitenansicht auf Teile der Primärseite des Röntgendiffraktometers von Fig. 3, mit mehreren Tiefenmessern am Referenzkörper;
- Fig. 9: eine schematische Schrägansicht auf Teile der Primärseite des Röntgendiffraktormeters, mit alternativer Laserentfernungsmessung in ein Röntgenoptikgehäuse hinein;
- Fig. 10: eine schematische Schnittansicht einer Röntgenquelle in einem Gehäuse für die Erfindung;
- Fig. 11a: eine schematische Seitenansicht auf Teile der Grundstruktur des Röntgendiffraktometers, vor der Befestigung des Referenzkörpers;
- Fig. 11b: eine schematische Seitenansicht auf Teile der Grundstruktur gemäß Fig. 11a, nach Befestigung des Referenzkörpers;
- Fig. 12: eine schematische Seitenansicht auf die Grundstruktur des Röntgendiffraktometers, mit befestigtem Referenzkörper und befestigter Haltevorrichtung;
- Fig. 13a-c: schematische Ansichten eines Steckelements einer Snap-Lock-Verbindung für die Erfindung, mit einer Aufsicht (13a), einer Seitenansicht (13b) und einer Schrägansicht (13c);
- Fig. 14a-c: schematische Ansichten eines Klemmelements einer Snap-Lock-Verbindung für die Erfindung, mit einer Aufsicht (14a), einer Seitenansicht (14b) und einer Schrägansicht (14c);
- Fig. 15a-c: schematische Ansichten eines Kollimators mit magnetischer Dreipunktaufnahme, mit Frontansicht (15a), Seitenansicht (15b) und Rückansicht (15c);
- Fig. 16a-b: schematische Ansichten einer Aufnahmevorrichtung für den Kollimator von Fig. 15a-c, mit einem Gegenstück der magnetischen Dreipunktaufnahme, mit Draufsicht (16a) und Seitenansicht (16b);
- Fig. 17: ein schematisches Ablaufdiagram einer Variante des erfindungsgemäßen Verfahrens zur Justage der Primärseite eines Röntgendiffraktometers gemäß der Erfindung.

### Hintergrund der Erfindung

Die Röntgendiffraktometrie wird seit Jahrzehnten für die strukturelle Bestimmung von Materie mit atomarer Auflösung eingesetzt. In der Einkristalldiffraktometrie sind dabei die Proben sehr klein, häufig kleiner als 100 µm. Ein typisches Einkristalldiffraktometer besteht aus folgenden Komponenten: Röntgenröhre zur Erzeugung von Röntgenstrahlung, Röntgenoptik zur Konditionierung der Röntgenstrahlung, Videomikroskop zur Zentrierung der Probe, Belichtungsshutter zur Steuerung der Probenbelichtung, Kollimator zur Begrenzung des Röntgenstrahlquerschnitts, Goniometer zur Orientierung der Probe, Primärstrahlfänger zur Absorption des Direktstrahls und einem Flächendetektor zur Messung der von der Probe gebeugten Röntgenstrahlung.

Typischerweise handelt es sich bei den in der Einkristalldiffraktometrie verwendeten Röntgenröhren um Punktfokusquellen mit einem runden optischen Fokus von ca. 50 µm Durchmesser. Als Röntgenröhren werden stationäre Mikrofokusröhren, Drehanoden oder auch Flüssigmetallquellen verwendet.

Bei der Röntgenoptik handelt es sich üblicherweise um Multilagen-Röntgenspiegel, sogenannte Montelspiegel (z.B. US 6,041,099 A). Diese Optiken sind mit Gradienten-Multilagen beschichtete Spiegel. Durch ihre parabolische oder paraboloide bzw. elliptische oder ellipsoide Oberfläche kollimieren bzw. fokussieren sie die in der Röntgenröhre erzeugte Röntgenstrahlung. Zusätzlich wirken diese Röntgenoptiken als Monochromatoren. Neben der Konditionierung soll die Röntgenoptik die Röntgenstrahlung auch auf die Probe lenken. Aufgrund der geringen Probengrößen in der Einkristalldiffraktometrie werden dafür typischerweise fokussierende Röntgenoptiken verwendet. Ziel ist es, trotz der geringen Probengröße, nur die Probe zu treffen, da andernfalls dies zu Störstrahlung führen und die Qualität der vom Flächendetektor aufgenommenen Daten verschlechtern kann.

Typische Reflexbreiten von Montelspiegeln liegen bei ca. 1 mrad (=0,057 Grad) für Cu-Ka-Röntgenstrahlung bzw. bei ca. 0,5 mrad (=0,028 Grad) für Mo-Kα-Röntgenstrahlung. Der Winkelbereich, in dem die Spiegel optimal reflektieren, ist also relativ schmal. Deshalb ist die genaue Justierung von Quelle bzw. Quellfokus und Röntgenoptik bei Fokusgrößen von typischerweise 100 µm sehr wichtig. Schon eine geringfügige Dejustierung führt zu deutlich schlechteren Röntgenstrahleigenschaften an der Probe.

Ein 1-Lochblenden Kollimator besitzt eine Lochblende unmittelbar vor der Probe mit dem Zweck die Abmessungen des Röntgenstrahls zu begrenzen, so dass dieser nur die Probe ausleuchtet. Typische Lochblendengrößen sind hierbei 100 µm oder 300 µm. Ein 2-Lochblenden-Kollimator besitzt zusätzlich eine Lochblende möglichst nahe am Spiegelausgang, mit dem Ziel die maximale Divergenz des Röntgenstrahls zu reduzieren. Typische Lochblendengrößen sind 500 µm eingangsseitig und 300 µm ausgangsseitig (in Strahlrichtung gesehen).

Die oben genannten Komponenten müssen nun so zueinander justiert werden, dass die Röntgenoptik die von der Röntgenröhre ausgehende Röntgenstrahlung optimal konditioniert. Der monochromatisierte, in zwei Dimensionen senkrecht zur Strahlausbreitungsrichtung geformte Röntgenstrahl muss weiterhin den Belichtungsshutter und Kollimator passieren, so dass ausschließlich die Probe mit einer maximalen Röntgenstrahlintensität ausgeleuchtet wird. Zusätzlich muss der die Probe anregende Röntgenstrahl so ausgerichtet sein, dass dieser senkrecht auf den Detektor trifft.

Zum aufeinander Ausrichten der Komponenten existieren nach Stand der Technik typischerweise mehrere Verstellschrauben an den Komponenten (z.B. US 7,511,902 B2). Außerdem wird der Justiervorgang von Beginn an mit Röntgenstrahlung durchgeführt. Da die Anforderungen an die Sicherheit heutiger Röntgensysteme gestiegen sind, dürfen Justierarbeiten am offenen Strahl nur noch sehr eingeschränkt oder gar nicht mehr durchgeführt werden. Deshalb befinden sich die Diffraktometer typischerweise in einer strahlensicheren Strahlenschutzbox, die gewährleistet, dass der Nutzstrahl bzw. die von der Probe ausgehende Streustrahlung durch geeignete Absorber, z.B. Bleiglas, blockiert wird. Da der gesamte Justiervorgang mit Hilfe von Röntgenstrahlung geschieht, muss für jeden Verstellschritt, also die Betätigung einer Verstellschraube, der Sicherheitsshutter geschlossen werden. Ein typischer Verstellschritt bedeutet demnach folgende Prozedur: 1) Sicherheitsshutter schließen, 2) Tür der Strahlenschutzbox öffnen, 3) Verstellschraube drehen, 4) Strahlenschutzbox schließen, 5) Sicherheitsshutter öffnen, 6) Detektor der Röntgenstrahlung aussetzen, 7) Detektor auslesen und Zählrate ermitteln. Der gesamte Vorgang dauert für einen einzelnen Verstellschritt typischerweise 30 s.

Nach dem Stand der Technik enthält der Justiervorgang der Primärseite eines Einkristalldiffraktometers folgende typische Schritte: 1) Einstellen der Monteloptik auf den Quellfokus mit anschließender Intensitätsmaximierung, 2) Justierung der Position bzw. Orientierung des Röntgenstrahls und des Kollimators zueinander, so, dass Röntgenstrahlung ausgangsseitig des Kollimators sichtbar wird, 3) Intensitätsmaximierung ausgangsseitig des Kollimators, 4) Ausrichten des Röntgenstrahls auf die Probe. Trifft nun der Röntgenstrahl nicht senkrecht auf den Detektor, muss die Orientierung der Monteloptik verändert werden, um die des Röntgenstrahls entsprechend anzupassen. Der Justiervorgang beginnt erneut bei Schritt 1). Für jeden der oben genannten Schritte muss eine Vielzahl von den oben beschriebenen, einzelnen Verstellschritten an den jeweiligen Verstellschrauben vorgenommen werden. Wenn schließlich der Quellfokus auf die Monteloptik so eingestellt ist, dass ein maximaler Photonenfluss hinter dem Kollimator auf die Probe und entsprechend senkrecht auf den Detektor trifft, wird abschließend noch ein Probekristall vermessen.

In dem oben beschriebenen, typischen Justierverfahren sind vor allem die Schritte 1) bis 3) sehr zeitintensiv und mühsam. Besteht eine große Fehlstellung zwischen Quellfokus und Monteloptik, reflektiert die Röntgenoptik praktisch nicht. Da ohne Reflektion an der Röntgenoptik nicht klar ist, wo die passende relative Position bzw. Orientierung zu finden ist, ist ein hoher Zeitaufwand notwendig, um diese durch sukzessive Veränderungen an den Verstellschrauben zu finden.

Da die Röntgenoptik und damit der von ihr konditionierte Röntgenstrahl eine relativ willkürliche Position und Orientierung hat, passiert der Röntgenstrahl mit hoher Wahrscheinlichkeit nicht einen mechanisch mittig gestellten Kollimator. Dies bedeutet, dass die Position bzw. Orientierung des Röntgenstrahls und damit die der Röntgenoptik auf die Position des Kollimators angepasst werden muss. Durch sukzessives Verändern der Strahlposition wird somit die Ebene der Kollimatoröffnung langwierig abgerastert, um einen Röntgenstrahl ausgangsseitig des Kollimators zu detektieren. Geschieht dieses Abrastern z.B. mit einem Optikgehäuse nach US 7,511,902 B2, dann wirken die Verstellschrauben über Exzenter auf die Spiegelrücken. Deren resultierende Bewegung ist demnach nicht linear, sondern sinusförmig, was die Positionsänderung des Ausgangsstrahls zur Ausrichtung auf die Kollimatoröffnung wenig intuitiv und damit zeitaufwendig macht. Außerdem kann es dabei passieren, dass man z.B. die Monteloptik zu weit verstellt, so dass der Röntgenspiegel nicht mehr reflektiert, was zu einem weiteren Zeitverlust führt.

Da jede einzelne Verstellung ca. 30 s dauert, kommt man leicht auf einen Justieraufwand nach dem Stand der Technik, der sich auf mehrere Tage beläuft. In ungünstigen Fällen ist ein Justieraufwand von einer Woche aufgetreten. Dieser Zustand ist unerfreulich, und macht den Bedarf nach einem verbesserten und vereinfachten Justierkonzept deutlich.

### Überblick zur Erfindung

Mit der vorliegenden Erfindung kann die Justierung der Primärseite eines Röntgendiffraktometers deutlich vereinfacht, beschleunigt und benutzerfreundlicher gemacht werden.

Das erfindungsgemäße Justierkonzept macht sich die Ellipsengleichung zu Nutze, welche theoretisch die ideale Position der einzelnen Komponenten festlegt. Demzufolge wird erfindungsgemäß vorgeschlagen, den Quellfokus der Röntgenquelle im ersten Brennpunkt mit großer Genauigkeit zu positionieren. Die Röntgenoptik soll ebenfalls, der Ellipsengleichung folgend, mit hoher Präzision so positioniert bzw. ausgerichtet werden, dass die Probe im zweiten Brennpunkt der Ellipse liegt (im Falle einer Parabel liegt der zweite Fokus im Unendlichen). Ist die lange Achse der Ellipse nun so ausgerichtet, dass sie senkrecht auf den Detektor zeigt, dann ist das Gesamtsystem ideal justiert. Weitere Komponenten wie die Kollimatoren sind ebenfalls an ihren idealen Soll-Positionen zu montieren.

In den letzten Jahren kam es zu einer stetigen Weiterentwicklung im Bereich der Röntgenoptiken, um die Röntgenintensität an der Probe zu verbessern bzw. um besser aufgelöste Röntgenbeugungsaufnahmen zu erhalten.

Multilagen-Spiegel können mit Beschichtungsfehlern von nur 0,2 % über die gesamte Spiegelfläche gefertigt werden, so dass der resultierende Winkelfehler für Cu- Kα-Röntgenstrahlung bei nur 0,001-0,004 Grad liegt, was deutlich kleiner als die Reflexbreite von 0,057 Grad für Cu-Ka-Strahlung ist. Analoges gilt für andere Strahlungsarten. Die Beschichtungen können daher als nahezu ideal betrachtet werden.

Ähnliches gilt für die Formfehler: Spiegel mit Formfehlern < 10 Winkelsekunden (Standardabweichung = root mean square r.m.s.) können heute in der Serienfertigung erreicht werden. Bei Annahme eines lokalen Winkelfehlers von typisch 5 Winkelsekunden = 5/3600 Grad = 0,0014 Grad = 2,44E-5 rad für einen Spiegel hoher Qualität ergibt sich auch hier ein Wert, der als nahezu ideal angesehen werden kann. Sollte sich das hier betrachtete Spiegelsegment 200 mm vom Probenfokus entfernt befinden, so wäre der Fokussierfehlerbeitrag = 2,44E-5 rad * 200 mm = 5 µm, also nur unwesentlich gegenüber dem idealen Wert von 100 µm.

Zusammengefasst kann also festgestellt werden, dass die heutigen Multilagen-Röntgenspiegel nahezu ideal hergestellt werden können. Die Erfinder haben erkannt, dass durch eine hohe Fertigungsqualität der Röntgenoptiken die Voraussetzung für das erfindungsgemäße hoch präzise Positionieren bzw. Ausrichten der Röntgenoptik gemäß der Ellipsengleichung auf geometrisch (ohne den Röntgenstrahl einzuschalten) bestimmte Sollwerte geschaffen ist, wodurch ein Großteil der bisherigen Justageschritte entfallen oder verkürzt werden kann.

Im Zuge der Erfindung wurde weiterhin die Frage bearbeitet, wie weit man sich mit einem realen System diesem idealen System laut Ellipsengleichung annähern kann. Dazu wurden ausgehend von einem Einkristalldiffraktometer nach dem oben beschriebenen Stand der Technik Fehlerfortpflanzungsrechnungen vorgenommen. Ein Ergebnis dieser Rechnungen war, dass verschiedene Komponenten nach dem Stand der Technik so miteinander verbunden sind, dass sich relativ lange und schlechte Toleranzketten ergeben, und die resultierenden aufsummierten Toleranzen weit zu hoch sind, um in den Bereich einer Justiergenauigkeit von wenigen 10 µm zu gelangen, die sich bei Verwendung von Quellgrößen von 35 µm oder Probengrößen von 100 µm zwangsläufig ergeben. Daher wurde der primärseitige Strahlpfad des Röntgendiffraktometers so umkonstruiert, dass sich möglichst kurze Toleranzketten ergeben. Im Zuge der Erfindung werden bevorzugt alle primärseitigen Komponenten direkt an eine gemeinsame Grundstruktur (auch genannt Grundkörper) montiert. Indirekte Montagen (über andere Komponenten) werden vermieden.

Außerdem wird in einer bevorzugten Ausführungsform vorgeschlagen, einen bevorzugt einzelnen, einstückigen Referenzkörper mit ausgebildeten Messstellen reversibel an der Grundstruktur zu befestigen, so dass mittels der Messstellen direkt über Abstandsmessungen gegenüber dem Referenzkörper die Sollpositionen bzw. Sollorientierungen der primärseitigen Komponenten, also Röntgenquelle, Röntgenoptik und Kollimator (bzw. dessen Kollimatoröffnung oder Kollimatoröffnungen), eingestellt werden können. Der Referenzkörper verlängert für die Vermessung und Einstellung der Komponenten die Grundstruktur. Der Referenzkörper zusammen mit den dadurch möglichen Abstandsmessungen verkürzt die Toleranzkette der Bauteile signifikant und macht eine rein mechanische Vorjustierung des Systems ohne Röntgenstrahlung derart genau möglich, dass bei Einschalten des Diffraktometers bereits durch die Röntgenoptik konditionierte Röntgenstrahlung ausgangsseitig des Kollimators messbar ist. Nur noch geringfügige Korrekturverstellungen sind notwendig, um einen maximalen Photonenfluss ausgangsseitig des Kollimators zu erreichen. Restfehler werden demnach über geeignete Verstellschrauben kompensiert. Im normalen Messbetrieb kann der Referenzkörper entfernt werden und stört diesen nicht.

Im Gegensatz zum Stand der Technik werden die primärseitigen Komponenten auf ihre Sollpositionen bzw. Sollorientierungen mechanisch, also ohne Röntgenstrahlung, voreingestellt. Dadurch können vor allem die weiter oben im Stand der Technik beschriebenen Justierschritte 1) bis 3), also das Einstellen der Monteloptik auf den Quellfokus mit anschließender Intensitätsmaximierung, die Justierung der Position bzw. Orientierung des Röntgenstrahls und des Kollimators zueinander, so, dass Röntgenstrahlung ausgangsseitig des Kollimators sichtbar wird und schließlich die Intensitätsmaximierung ausgangsseitig des Kollimators, deutlich beschleunigt und nutzerfreundlicher werden. Die Anzahl der einzelnen, oben beschriebenen Verstellschritte wird stark reduziert.

Eine Veränderung der Strahlposition durch gleiches Verfahren der Röntgenoptik und Röntgenquelle ist leicht und intuitiv möglich, wenn wie in einer Ausführungsform vorgesehen die entsprechenden Verstellschrauben der Röntgenoptik und Röntgenquelle die gleiche Ganghöhe aufweisen. Durch diese Neuerung wird außerdem die Wahrscheinlichkeit deutlich reduziert, den Quellfokus und die Röntgenoptik relativ zueinander so stark zu verstellen, dass der Röntgenspiegel nicht mehr reflektiert, was zu weiteren Zeitverlusten führen würde.

Weiterhin können die Qualität der Röntgenoptiken sowie die Positioniergenauigkeit bzgl. der Sollposition bzw. Sollorientierung so hoch eingerichtet werden, dass in der Regel der durch den Röntgenspiegel konditionierte und den Kollimator passierende Röntgenstrahl senkrecht auf den Detektor fällt. Dies macht eine im Stand der Technik beschriebene Wiederholung der Justierschritte überflüssig, wodurch eine weitere Beschleunigung der Justierung der Primärseite eines Röntgendiffraktometers erreicht wird.

Ein weiterer Vorteil der Erfindung besteht darin, dass nach vollständiger Justierung des Diffraktometers abschließend die Ist-Position bzw. Ist-Orientierung der Röntgenquelle, Röntgenoptik und des Kollimators über Abstandsmessungen gegenüber dem Referenzkörper (oder allgemein gegenüber der Grundstruktur) vermessen und notiert werden kann. Ist nun das System durch unterschiedlichste Gründe dejustiert worden, z.B. durch Umzug des Diffraktometers, durch Dejustierung durch einen ungeschulten Nutzer, durch ein Erdbeben etc., dann kann das System mit Hilfe des Referenzkörpers und der notierten Abstandswerte (bzw. allgemein der Grundstruktur und der notierten Positions- und Orientierungsdaten) schnell wieder in einen justierten Zustand gebracht werden. Dies ist nach Stand der Technik bisher so nicht möglich.

### Ausführungsformen eines erfindungsgemäßen Röntgendiffraktometers

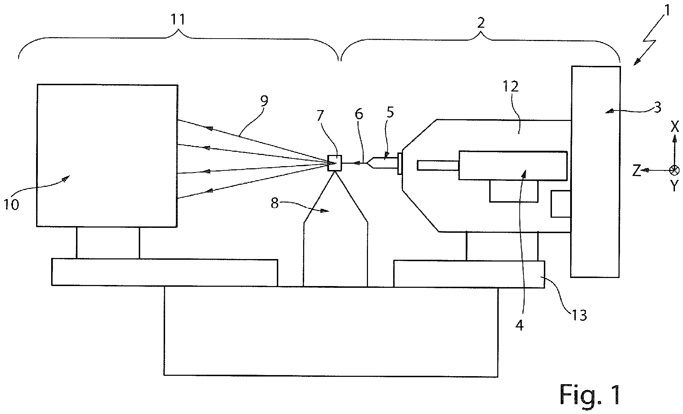

Die **Fig. 1** zeigt eine Ausführungsform eines Röntgendiffraktometers 1, insbesondere Einkristall-Röntgendifraktometers. Das Röntgendiffraktometer 1 weist eine Primärseite (Bereich des Primärstrahlpfads) 2 auf, die eine Röntgenquelle 3 (bevorzugt eine Punktfokusquelle mit einer Fokusgröße zwischen 20-100 µm oder auch mit einer Fokusgröße von 35µm oder weniger), eine Röntgenoptik 4 und einen Kollimator 5 umfasst. Der mit der Primärseite 2 erzeugte Röntgenstrahl 6 propagiert in z-Richtung und trifft auf eine Probe 7, die auf einem Goniometer 8 angeordnet und mit diesem verdrehbar ist; bevorzugt ist das Goniometer 8 als 3-achsiges Goniometer ausgebildet. Von der Probe 7 ausgehende, gebeugte Röntgenstrahlung 9 wird von einem zweidimensionalen Detektor 10 registriert. Die von der Probe 7 ausgehende Röntgenstrahlung 9 und der Detektor 10 gehören zur Sekundärseite (Bereich des Sekundärstrahlpfades) 11 des Röntgendiffraktometers 1.

Die Röntgenquelle 3, die Röntgenoptik 4 und der Kollimator 5 sind hier jeweils unabhängig voneinander an einer Grundstruktur 12 befestigt und gegenüber dieser in weiter unten beschriebener Weise unabhängig voneinander verstellbar. Die Grundstruktur 12 ihrerseits ist gegenüber einem Fußelement 13 in weiter unten beschriebener Weise verstellbar. Das Fußelement 13 ist hier starr mit dem Goniometer 8 verbunden.

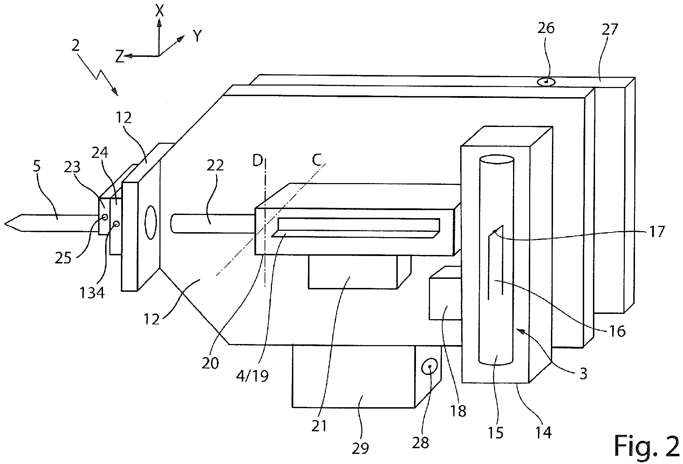

In **Fig. 2** wird die Primärseite 2 des Röntgendiffraktometers näher erläutert.

Die Röntgenquelle 3 ist hier als eine Röntgenröhre 15 ausgebildet, die in einem Gehäuse 14 der Röntgenquelle 3 angeordnet ist. In der Röntgenröhre 15 ist eine Anode 16 angeordnet, die an der Stelle, wo beschleunigte Elektronen auf die Anode 16 treffen, einen Quellfokus 17 ausbildet. Das Gehäuse 14, und damit auch die Röntgenröhre 15, ist mit einer verstellbaren Befestigungsvorrichtung 18 an der Grundstruktur 12 befestigt. Am Gehäuse 14 ist ein Shutter (nicht näher dargestellt) zum Blockieren des im Wesentlichen in z-Richtung propagierenden Röntgenstrahls (nicht eingezeichnet) ausgebildet. Die Röntgenoptik 4 ist hier mit einem Montelspiegel (Monteloptik) 19, umfassend zwei im rechten Winkel angeordnete Gradienten-Multischichtspiegel, ausgebildet, wobei der Montelspiegel 19 in einem Gehäuse 20 der Röntgenoptik 4 in definierter (bekannter Weise) angeordnet ist, so dass aus der Position und Orientierung des Gehäuses 20 auf die Position und Orientierung der Röntgenoptik 4 geschlossen werden kann. Das Gehäuse 20, und damit auch die Röntgenoptik 4, ist über eine verstellbare Haltevorrichtung 21 an der Grundstruktur 12 befestigt. Am Gehäuse 20 ist hier auch ein Helium-Strahlrohr 22 angeordnet, mit dem Luftstreuung bzw. Luftabsorption des Röntgenstrahls minimiert wird.

Der Kollimator 5, der an der Spitze seines Strahlrohrs in Fig. 2 am vorderen, linksseitigen Ende eine (erste) Kollimatoröffnung (Lochblende) ausbildet, ist mit einem plattenförmigen Grundelement 23 ausgestattet, mit dem das Strahlrohr horizontal (in y-Richtung) und vertikal (in x-Richtung) translatiert werden kann, vgl. die Verstellschraube 25. Das Grundelement 23 ist über ein Halterungselement 24 an der Grundstruktur 12 befestigt. Falls, wie hier, ein 2-Lochblenden-Kollimator verwendet werden soll, enthält das Halterungselement 24 auch eine zweite Kollimatoröffnung (zweite Lochblende) (in der Fig. 2 verdeckt) und Verstellelemente (vgl. Verstellschraube 134) für eine Translation der zweiten Lochblende.

Die Grundstruktur 12 kann mittels eines Verstellelements (hier einer Verstellschraube 26) an einem Träger 27 gegenüber dem Fußelement (nicht eingezeichnet) um eine Achse C (die parallel zur y-Richtung verläuft) verschwenkt werden. Weiterhin kann die Grundstruktur 12 mit einem Verstellelement (hier einer Verstellschraube 28) an einem Träger 29 um eine Achse D (die parallel zur x-Achse verläuft) verschwenkt werden. In einer alternativen Bauform kann über die Verstellschraube 26 die Grundstruktur 12 gegenüber dem Fußelement vertikal (in x-Richtung) verfahren werden, und über die Verstellschraube 28 die Grundstruktur 12 horizontal (in y-Richtung) verfahren werden.

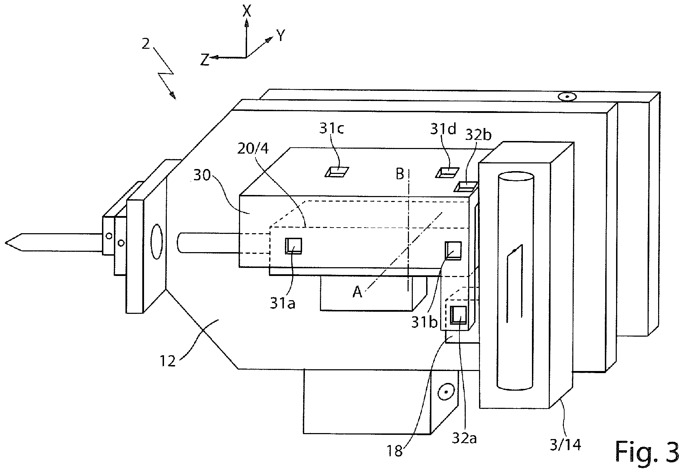

In der **Fig. 3** ist die Primärseite 2 von Fig. 2 nochmals dargestellt, wobei nunmehr auch ein Referenzkörper 30 an der Grundstruktur 12 angeordnet ist. Der Referenzkörper 30 ist in definierter Weise an der Grundstruktur 12 (reversibel) befestigt worden, so dass über eine Bestimmung der Position oder Orientierung von Bauelementen der Primärseite 2 zum Referenzkörper 30 auf die Position oder Orientierung dieser Bauelemente bezüglich der Grundstruktur 12 geschlossen werden kann.

Am Referenzkörper 30 sind hier vier Messstellen (Öffnungen) 31a-31d ausgebildet, mit denen ein eingesetzter Tiefenmesser (nicht dargestellt) den Abstand einer vorderen Seitenfläche bzw. einer Oberseite des Gehäuses 20 der Röntgenoptik 4 zu einer vorderen Seitenfläche bzw. einer Oberseite des Referenzkörpers 30 in einem linksseitigen und einem rechtsseitigen Teil bestimmen kann. Diese vier Abstandsinformationen genügen, um die Position der Röntgenoptik 4 (bzw. deren Gehäuse 20) bezüglich der Richtungen x und y und der Orientierung der Röntgenoptik 4 bezüglich der zueinander orthogonalen Achsen A (die parallel der y-Richtung verläuft) und B (die parallel zur x-Richtung verläuft) zu bestimmen.

Weiterhin sind am Referenzkörper 30 zwei Messstellen (Öffnungen) 32a-32b ausgebildet, mit denen der Tiefenmesser Abstände eines (jeweiligen) Teils der Befestigungsvorrichtung 18, an dem das Gehäuse 14 der Röntgenquelle 3 in bekannter Weise (zumindest bezüglich der relevanten Richtung) befestigt ist, zum Referenzkörper 30 bestimmen kann. Die Messstellen 32a, 32b sind dabei wiederum an der vorderen Seitenfläche und an der Oberseite des Referenzkörpers 30 ausgebildet, und gestatten eine Abstandsmessung zu einer vorderen Seitenfläche und einer Oberseite des besagten (jeweiligen) Teils der Befestigungsvorrichtung 18. Dadurch lässt sich die Position der Röntgenquelle 3 bezüglich der Richtungen x, y zur Grundstruktur 12 bestimmen.

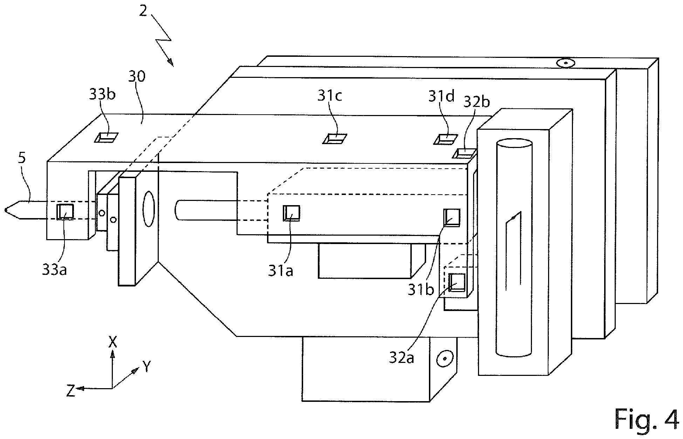

Die **Fig. 4** illustriert eine Variante des Referenzkörpers 30, bei der dieser auch den Kollimator 5 übergreift. Mit Messstellen (Öffnungen) 33a, 33b an der vorderen Seitenfläche und der Oberseite des Referenzkörpers 30 kann ein Tiefenmesser auch den Abstand in x-Richtung und in y-Richtung zum Strahlrohr des Kollimator 5 bestimmen, wodurch auf die Position der Kollimatoröffnung an der (in Fig. 4 linksseitigen) Spitze des Strahlrohrs des Kollimators 5 geschlossen werden kann.

Man beachte, dass in den beiden Varianten von Fig. 3 und Fig. 4 jeweils alle Messstellen 31a-31d, 32a-32b, 33a-33b am selben, einstückigen Bauteil, nämlich dem Referenzkörper 30, ausgebildet sind.

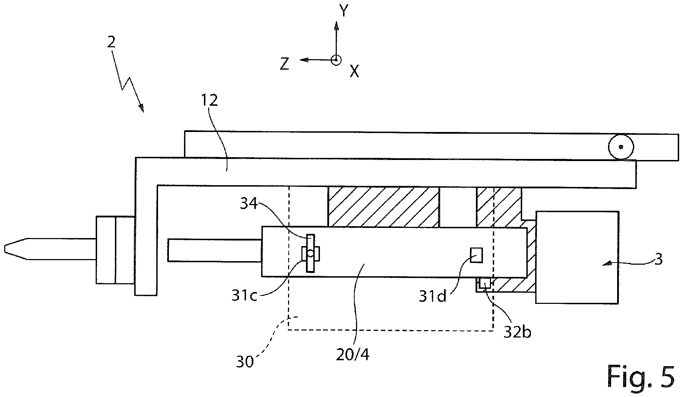

Die **Fig. 5** zeigt eine Aufsicht auf die Primärseite 2, wie in Fig. 3 dargestellt, wobei der Referenzkörper 30 transparent und mit gestrichelten Konturen eingezeichnet ist. In der Messstelle 31c ist hier ein mechanisches Abtastelement (Tiefenmesser) 34 eingesetzt worden, mit dem der Abstand in x-Richtung (senkrecht zur Zeichenebene) des Referenzkörpers 30 zum Gehäuse 20 der Röntgenoptik 4 gemessen werden kann. Der Tiefenmesser hat eine Messgenauigkeit von ca. 10 µm.

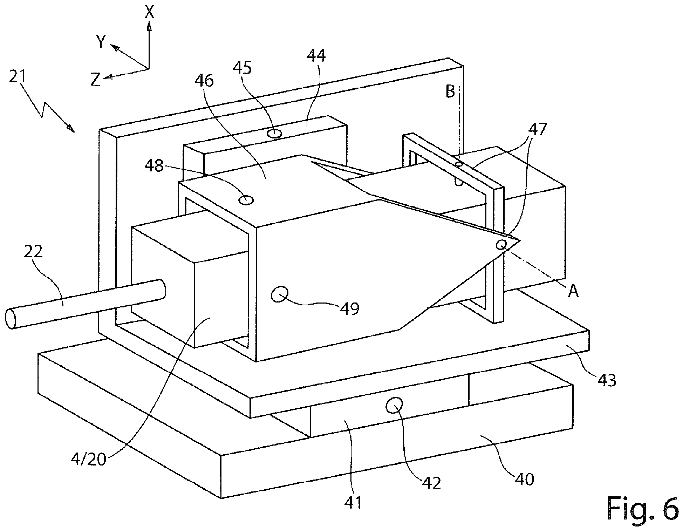

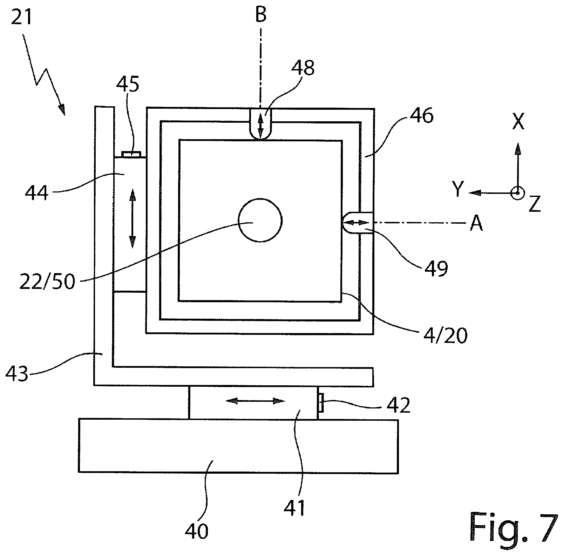

Die **Fig. 6** in Schrägansicht und **Fig. 7** in Frontalansicht illustrieren die Befestigung und Verstellung der Röntgenoptik 4 an der Grundstruktur mittels der Haltevorrichtung 21 näher.

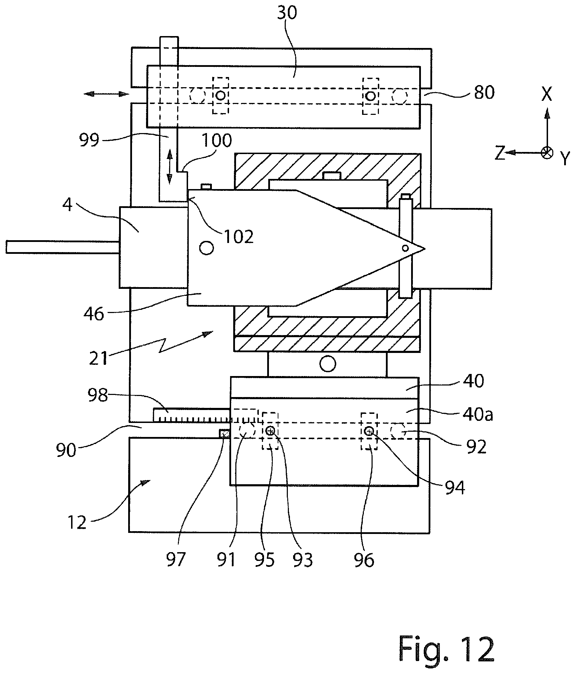

Die Haltevorrichtung 21 verfügt über ein Basiselement 40, das über ein Unterbasiselement (nicht dargestellt) der Haltevorrichtung 21 an der Grundstruktur (ebenfalls nicht dargestellt) befestigt ist, etwa mit Stiften in einer Nut und Fixierschrauben (vgl. dazu Fig. 12) an der Rückseite.

Über eine Verstelleinrichtung 41 mit einer Verstellschraube 42 kann ein im Querschnitt L-förmiger Träger 43 horizontal (in y-Richtung) gegenüber dem Basiselement 40 translatiert werden. Über eine Verstelleinrichtung 44 mit einer Verstellschraube 45 kann wiederum ein Zwischenelement 46 vertikal (in x-Richtung) gegenüber dem Träger 43 translatiert werden.

Im Zwischenelement 46 ist wiederum die Röntgenoptik 4 gelagert; das Zwischenelement 46 umgreift dabei die Röntgenoptik 4. Die Röntgenoptik 4 bzw. deren Gehäuse 20 (einschließlich des befestigten He-Strahlrohrs 22) kann im Zwischenelement 46 um die horizontale Achse A und um die vertikale Achse B geschwenkt werden. Hierfür ist am Zwischenelement 46 eine kardanische Aufhängung 47 eingerichtet. Die Verkippung um die Achse A wird mittels einer Verstelleinrichtung (hier Verstellschraube) 48, und die Verkippung um die Achse B wird mit einer Verstelleinrichtung (hier Verstellschraube) 49 eingestellt. Die Verstellschrauben 48, 49 sind in Gewindebohrungen des Zwischenelements 46 geführt und stützen sich endseitig am Gehäuse 20 der Röntgenoptik 4 ab.

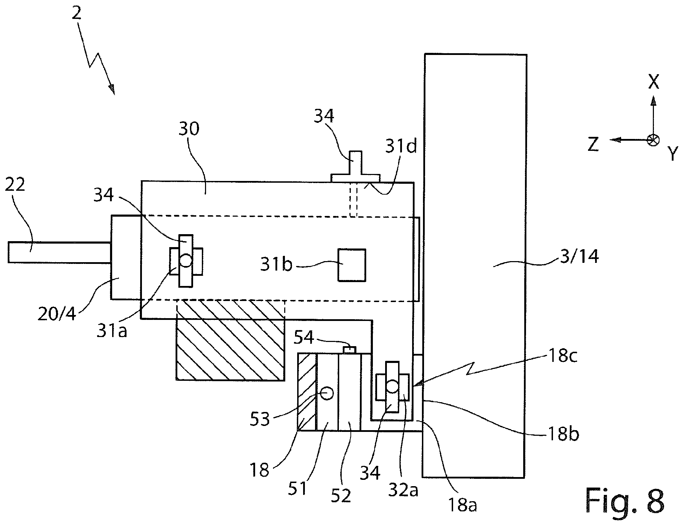

Die **Fig. 8** zeigt eine Seitenansicht auf die Primärseite 2 von Fig. 3. Am Referenzkörper 30 sind hier drei mechanische Abtastelemente (Tiefenmesser) 34 als Messeinrichtungen an Messstellen eingesetzt, nämlich an den Messstellen 31a, 31d und 32a.

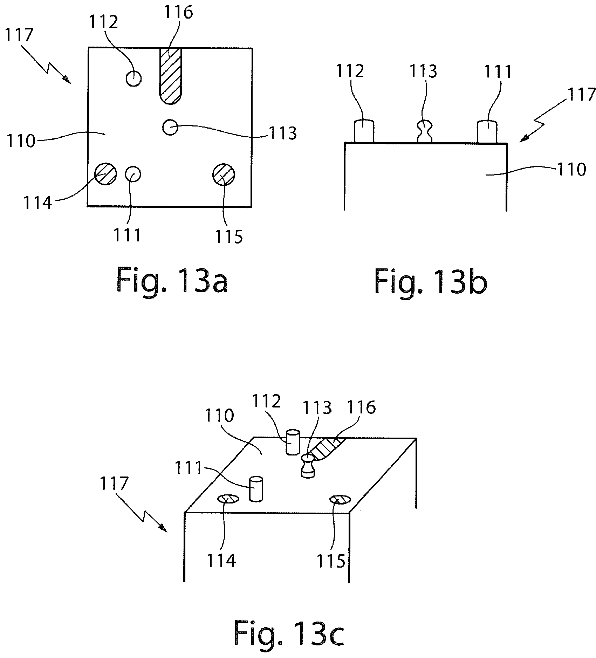

An der Messstelle 32a wird mit dem Abtastelement 34 ein Teil der Befestigungsvorrichtung 18 kontaktiert, nämlich eine Zwischenhalterung 18a. Die Zwischenhalterung 18a ist an einem Stoß 18b mit der Röntgenröhre 3 bzw. dessen Gehäuse 14 in bekannter, reversibler Weise verbunden, hier mit einem Snap-Lock 18c (vgl. hierzu auch Fig. 13a-13c); alternativ wäre auch ein so genanntes Quick-Lock möglich. In der Fig. 8 sind auch die Verstelleinrichtung 51 für eine horizontale (y) Verstellung und die Verstelleinrichtung 52 für eine vertikale (x) Verstellung der Zwischenhalterung 18a, und damit auch der Röntgenquelle 3, mittels der Stellschrauben 53, 54 ersichtlich. Bei Austausch der Röntgenröhre 3 kann die Zwischenhalterung 18a in justierter Stellung verbleiben.

An der Messstelle 31d ragt der das mechanisches Abtastelement 34 mit einem Dorn bis an die Oberseite des Gehäuses 20 der Röntgenoptik 4. Aus dem Ausfahrweg des Dorns ergibt sich der Abstand zur Messstelle 31d.

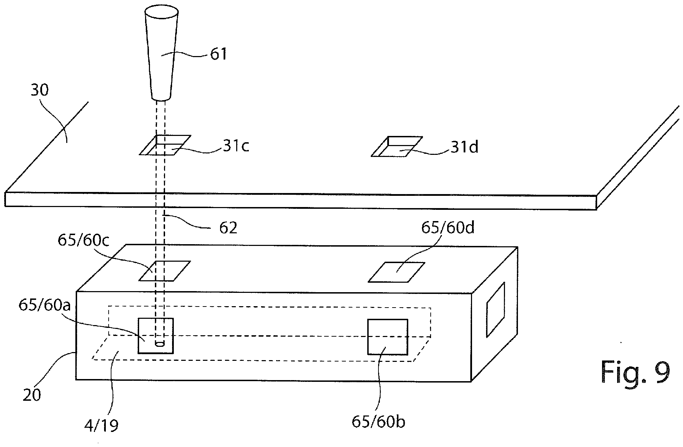

**Fig. 9** illustriert eine alternative Variante zur Bestimmung der Position und der Orientierung einer Röntgenoptik 4. Die Röntgenoptik 4 ist in einem Gehäuse 20 angeordnet, welches mehrere, für sichtbares Licht transparente (aber für Röntgenstrahlung intransparente) Fenster 60a-60d aufweist. Die Fenster 60a-60d sind mit einem optisch transparenten Material 65, das für die Röntgenstrahlung undurchlässig ist (Abschwächung bevorzugt um wenigstens einen Faktor 1000 bei Cu Kα), beispielsweise Bleiglas, ausgebildet.

Von der Messstelle 31c im Referenzkörper 30 aus kann mit einer Laserentfernungsmesselement 61, die in nicht näher dargestellter Weise in der Messstelle 31c verankert (und entsprechend definiert positioniert) ist, ein Laserstrahl 62 ins Innere des Gehäuses 20 auf die eigentliche Röntgenoptik 4, hier einen Montelspiegel 19, gerichtet werden. Beispielsweise über die Laufzeit des Laserstrahls 62 zurück zur Laserentfernungsmesselement 61 kann dann auf den Abstand der Röntgenoptik 4 zur Messstelle 31c geschlossen werden.

Entsprechend kann der Abstand der Röntgenoptik 4 bezüglich anderer Messstellen (vgl. 31d, und weiter 31a, 31b vgl. Fig. 3) mit den anderen Fenstern 60d, 60a, 60b gegenüber dem Referenzkörper 30 bestimmt werden. In dieser Variante kann die Verstellung der Röntgenoptik 4 auch im Inneren des Gehäuses 20 erfolgen.

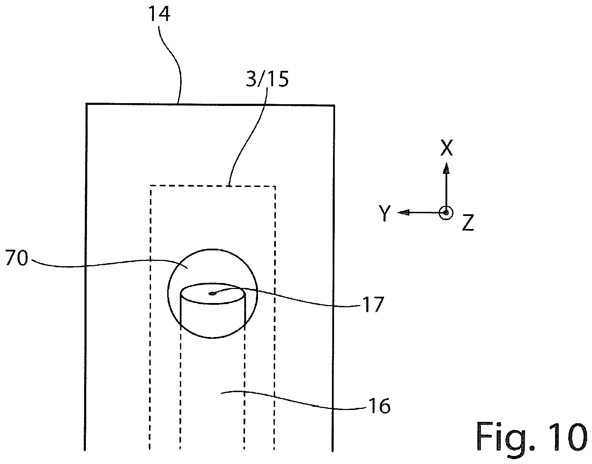

Die **Fig. 10** zeigt in einer Frontalansicht die Röntgenquelle 3 von Fig. 1. Die Röntgenquelle 3, hier eine Röntgenröhre 15, ist im Gehäuse 14 angeordnet. Der Quellfokus 17 auf der Anode 16 sitzt dabei hinter einer Shutteröffnung 70, die bei Bedarf mit einer röntgendichten Abdeckung ("Shutter", nicht dargestellt) blockiert werden kann. Für die Erfindung ist der Quellfokus 17 an einer definierten Position innerhalb des Gehäuses 14 angeordnet, so dass über eine geeignete Positionierung des Gehäuses 14 der Quellfokus 17 in einer gewünschten Weise platziert werden kann. In vielen Fällen kann der Hersteller der Röntgenquelle 3 die Röntgenröhre 15 und den Quellfokus 17 ausreichend genau im Gehäuse 14 platzieren, so dass bei der Justage eines Röntgendiffraktometers im Rahmen der Erfindung die herstellerseitige Platzierungsinformation direkt herangezogen werden kann.

Anderenfalls ist es auch möglich, zur Kalibrierung zunächst in einem Vorversuch die Position des Quellfokus17 relativ zum Gehäuse 14 zu bestimmen, etwa relativ zu einem Orientierungspunkt im Gehäuse, um daraus einen Offset (Korrekturwert oder Korrekturwerte) für die Positionierung des Gehäuses 14 an der Grundstruktur zu bestimmen. In einer anderen Variante ist die Position der Röntgenröhre 15 - und damit auch die Position des Quellfokus 17 - im Gehäuse 14 verstellbar (zumindest in einer Richtung, hier entlang der Röhrenachse, entspricht x-Richtung), und wird in einem Vorversuch auf eine gewünschte (für die weitere Positionierung der Röntgenquelle 3 vorausgesetzte) Position relativ zum Gehäuse 14 ("Fokussollwert") eingestellt und dort fixiert.

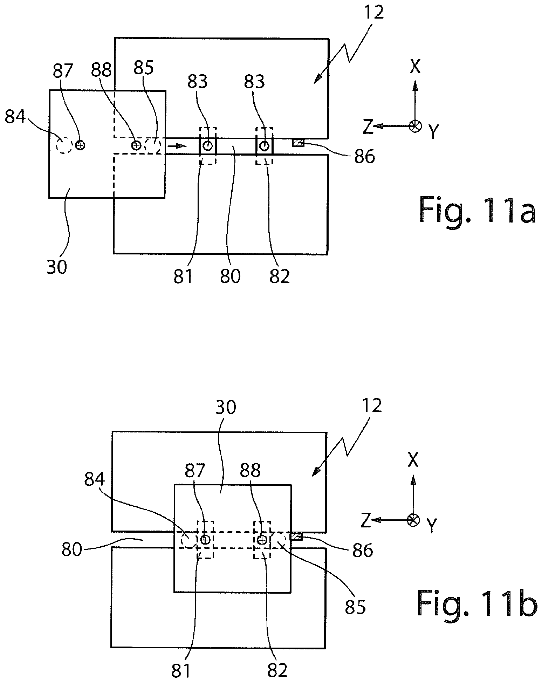

Die Figuren 11a und 11b illustrieren eine reversible, exakte Befestigung des Referenzkörpers 30 an der Grundstruktur 12.

Wie in **Fig. 11a** ersichtlich, weist die Grundstruktur 12 eine parallel zur z-Richtung verlaufende Führung 80, hier ausgebildet als ein Spalt oder eine Nut, auf. Von der Rückseite ragen zwei Nutensteine 81, 82 in die Führung; die Nutensteine 81, 82 sind in der Führung 80 verschiebbar. Die Nutensteine 81, 82 weisen jeweils Gewindebohrungen 83 auf.

In der Führung 80 ist der Referenzkörper 30 mit zwei rückwärtigen Stiften 84, 85 verfahrbar. Wird der Referenzkörper 30 in der Führung 80 nach (hier) rechts verfahren, stößt der Referenzkörper 30 schließlich seitlich an ein Anschlagelement 86 der Grundstruktur 12. Die **Fig. 11b** zeigt die entsprechende Endposition.

In der Endposition können die Nutensteine 81, 82 so verfahren werden, dass die zwei Feststellschrauben 87, 88 am Referenzkörper 30 über den Gewindebohrungen der Nutensteine 81, 82 angeordnet sind, so dass der Referenzkörper 30 mittels der Feststellschrauben 87, 88 an die Nutensteine 81, 82 herangezogen werden kann und somit mittels der Nutensteinen 81, 82 in y-Richtung verspannt werden kann. Dann ist der Referenzkörper 30 insgesamt ortsfest gehalten.

Durch die Führung 80 und die Stifte 84, 85 ist der Referenzkörper 30 in x-Richtung und durch die Verspannung auf der Grundstruktur 12 in y-Richtung reproduzierbar und genau platziert. Die Position in z-Richtung wird hierdurch das Anschlagelement 86 vorgegeben; man beachte, dass für die Justage eines Röntgendiffraktometers die Röntgenoptik in z-Richtung weniger genau platziert werden muss als in x und y.

Zum Entfernen des Referenzkörpers 30 können die Feststellschrauben 87, 88 gelöst und der Referenzkörper 30 von der Führung 80 wieder abgezogen werden.

Die **Fig. 12** zeigt eine Seitenansicht eines Teils der Primärseite 2 von Fig. 3, zur Illustration der Befestigung von Bauelementen an der Grundstruktur 12.

Im oberen Drittel ist eine (reversible) Befestigung des Referenzkörpers 30 in der Führung 80 ersichtlich, die weitgehend dem Aufbau von Fig. 11a, 11b entspricht. Jedoch ist hier das Anschlagelement 99 am Referenzkörper 30 ausgebildet und in x-Richtung verfahrbar. Das Anschlagelement 99 liegt in der gezeigten, ausgefahrenen Stellung mit einer Nase 100 am Zwischenelement 46 an. Gegenseitige Anschlagflächen 102 von Nase 100 und Zwischenelement 46 liegen parallel zur x-und y-Richtung, wodurch eine definierte Position des Referenzkörpers 30 in z-Richtung eingenommen wird. Das ausfahrbare Anschlagelement 99 ermöglicht es, den Referenzkörper 30 definiert bezüglich der z-Richtung in beliebigen Verstellpositionen in x und y des Zwischenelements 46 auszurichten. Typischerweise wird der Referenzkörper 30 entlang der Führung 80 verschoben, bis die Nase 100 des Anschlagelements 99 am Zwischenelement 46 anliegt. Sodann wird (unter Beibehaltung der z-Position des Referenzkörpers 30) das Anschlagelement 99 nach oben zurückgezogen, und der Referenzkörper 30 durch Festziehen der Feststellschrauben 87, 88 fixiert. Durch dieses Vorgehen ist ausgeschlossen, dass durch das Anschlagelement 99 beim Festziehen der Feststellschrauben 87, 88 Kräfte auf das Zwischenelement 46 übertragen werden, die die Position der Röntgenoptik 4 verfälschen könnten.

In entsprechender Weise wie der Referenzkörper 30 wird auch die Haltevorrichtung 21 bezüglich der z-Richtung an der Grundstruktur 12 positioniert. Die Haltevorrichtung 21 umfasst hier ein Basiselement 40, das über eine Verstiftung, insbesondere eine Snap-Lock-Verbindung oder Quick-Lock-Verbindung (nicht näher dargestellt), auf einem Unterbasiselement 40a der Haltevorrichtung 21 in bekannter und reversibler Weise befestigt, insbesondere aufgesteckt und verklemmt, ist. Das Unterbasiselement 40a wiederum wird in einer parallel zur z-Richtung verlaufenden Basisführung 90 mittels Stiften 91, 92 und Feststellschrauben 93, 94, die an Nutensteinen 95, 96 verspannt sind, gehalten. Über die Stifte 91, 92 und die Basisführung 90 wird die x-Position der Haltevorrichtung 21 eingestellt, und durch die Verspannung mit den Nutensteinen wird die y-Position der Haltevorrichtung 21 eingestellt. Das Unterbasiselement 40a kann bis zu einem (festen) Endanschlag 97 der Grundstruktur 12 verfahren werden; alternativ kann die z-Position des Unterbasiselements 40a auch mit einer Skala 98 eingestellt werden. Wie bereits angemerkt muss für die Justage eines Röntgendiffraktometers die Röntgenoptik 4 in z-Richtung weniger genau platziert werden als in x und y.

In **Fig. 13a** (in Aufsicht), **Fig. 13b** (in Seitenansicht) und **Fig. 13c** (in Schrägansicht) wird ein Steckelement 110 einer Klemmhalterung 117 nach Art einer Snap-Lock-Verbindung vorgestellt, die im Rahmen der Erfindung zur reversiblen, aber genau reproduzierbaren Befestigung von Bauelementen (etwa der Röntgenoptik, der Röntgenquelle oder des Kollimators oder eines Kollimatorteils) insbesondere an der Grundstruktur verwendet werden kann. Die Snap-Lock-Verbindung erleichtert insbesondere im Rahmen einer Zwischenhalterung einen Austausch eines einzelnen Bauelements, indem Justageaufwand vermieden wird. Eine Zwischenhalterung 18a kann beispielsweise bei der Befestigungsvorrichtung 18 für das Gehäuse 14 der Röntgenquelle 3 eingesetzt werden (vgl. Fig. 8).

Das Steckelement 110 weist hier zwei gerade Stifte 111, 112 und einen eingeschnürten Stift 113 für eine Arretierung auf, die in einer Dreiecksanordnung von einer Seite des Steckelements 110 abstehen. Weiterhin sind zwei runde Vertiefungen (Mulden) 114, 115 und eine langgestreckte Vertiefung (Mulde) 116 auf derselben Seite vorgesehen. Eine der runden Vertiefungen 114, 115 ist hier kegelförmig eingesenkt, und die andere der Vertiefungen 114, 115 zylindrisch eingesenkt. Die Vertiefungen 114-116 bilden einen ersten Teil einer Dreipunkt-Aufnahme aus.

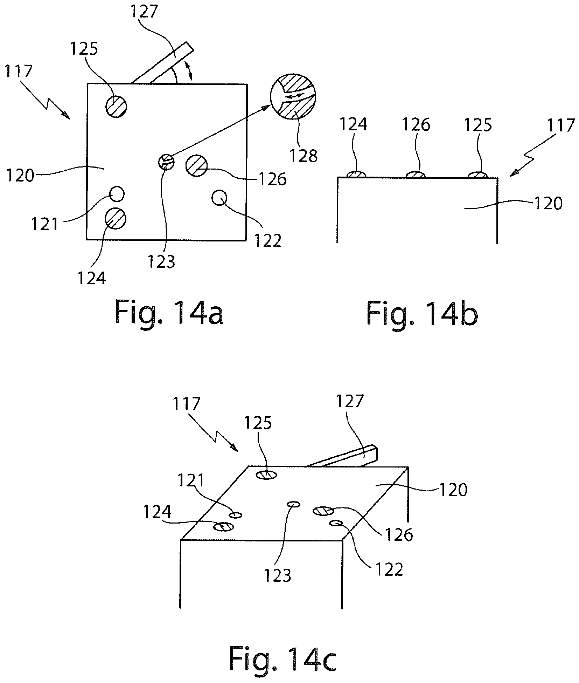

Ein Klemmelement 120 der Klemmhalterung 117, dargestellt in **Fig. 14a** (in Aufsicht), in **Fig. 14b** (in Seitenansicht) und in **Fig. 14c** (in Schrägansicht), ist mit zwei Löchern 121, 122 für die Aufnahme der Stifte 111, 112 (siehe Fig. 13c) und mit einem Loch 123 mit Klemmfunktion für die Aufnahme des eingeschnürten Stifts 113 (siehe Fig. 13c) ausgebildet. Im Rahmen der Snap-Lock-Verbindung kann über einen Hebel 127 dabei eine Klemmeinrichtung 128 mit einer Ausnehmung in den Bereich des Lochs 123 eingeschwenkt werden, wodurch das Steckelement über den eingeschnürten Stift an das Klemmelement 120 herangezogen wird. Dadurch, dass der Hebel 127 zwischen Endstellungen hin- und hergeklappt wird, ist die Klemmkraft der Klemmeinrichtung 128 genau definiert und reproduzierbar.

Im Falle einer Ausbildung der Klemmvorrichtung 117 als Quick-Lock (nicht dargestellt) wird die Klemmkraft nicht über einen Hebel, sondern mit Hilfe eines Drehmomentschlüssels mit festgelegtem Drehmoment an einer Spannschraube eingestellt; auch dadurch kann eine gut reproduzierbare Klemmkraft erhalten werden.

Am Klemmelement 120 sind weiterhin drei kugelschalenförmige Vorsprünge 124, 125, 126 ausgebildet, die sich in die Vertiefungen 114, 115, 116 (siehe Fig. 13c) einlegen und selbstzentrierend für die definierte gegenseitige Ausrichtung von Steckelement und Klemmelement 120 sorgen. Die Vorsprünge 124-126 bilden den zweiten Teil der Dreipunktaufnahme aus.

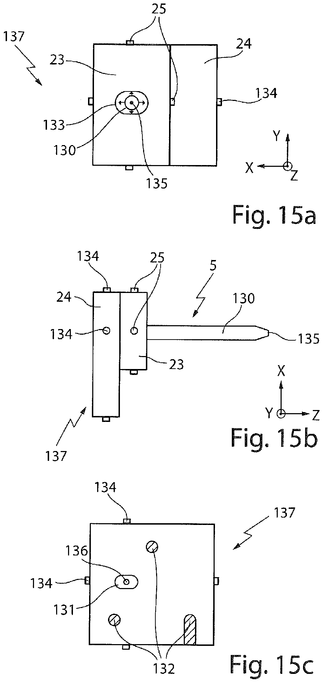

In den **Fig. 15a** (in Frontansicht), **Fig. 15b** (in Seitenansicht) und **Fig. 15c** (in Rückansicht) ist eine Magnethalterung 137 für einen Kollimator 5 mit magnetischer Dreipunktaufnahme illustriert, die im Rahmen der Erfindung eingesetzt werden kann. Der Kollimator 5 muss im Rahmen der erfindungsgemäßen Justage gelegentlich entfernt und wieder eingesetzt werden, wofür die Magnethalterung 137 sehr gut geeignet ist.
Eine magnetische Dreipunktaufnahme kann auch im Rahmen einer Zwischenhalterung im Rahmen der Erfindung zur reversiblen, aber genau reproduzierbaren Befestigung von Bauelementen (etwa der Röntgenoptik, der Röntgenquelle oder des Kollimators oder eines Kollimatorteils) insbesondere an der Grundstruktur verwendet werden.

Das Strahlrohr 130 des Kollimators 5 ist an einem Grundelement 23 befestigt, das mittels Verstellschrauben 25 eine Verstellung der Position (Translation in x, y) des Strahlrohrs 130 vor einem Durchbruch 133 gestattet. Die Spitze des Strahlrohrs 130 bildet eine erste Kollimatoröffnung 135 bzw. eine erste Lochblende (Austrittsöffnung) für den Röntgenstrahl aus. Das Grundelement 23 ist auf einem Halterungselement 24 befestigt, das mit Verstellschrauben 134 eine Verstellung der Position (Translation in x, y) einer Blende 131 mit einer zweiten Kollimatoröffnung 136 bzw. einer zweiten Lochblende ermöglicht. Das Halterungselement 24 ist weiterhin mit einem ersten Teil einer magnetischen Dreipunktaufnahme 132, mit zwei runden Vertiefungen (insbesondere einerseits kegelförmig und andererseits zylindrisch eingesenkt) und einer länglichen Vertiefung, an seiner Rückseite ausgestattet.

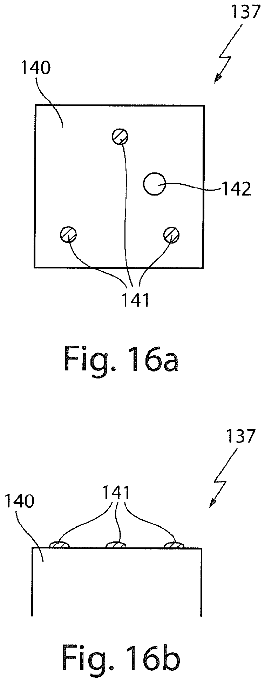

In **Fig. 16a** (in Aufsicht) und **Fig. 16b** (in Seitenansicht) ist eine Aufnahmevorrichtung 140 der Klemmhalterung 137 für den Kollimator von Fig. 15a-15c dargestellt. Die Aufnahmevorrichtung 140 ist typischerweise fest mit der Grundstruktur verbunden. Man beachte, dass die Aufnahmevorrichtung 140 auch für die zeitweise Aufnahme eines 2D-Detektors genutzt werden kann.

Die Aufnahmevorrichtung 140 bildet den zweiten Teil einer magnetischen Dreipunktaufnahme 141 mit drei kugelschalenförmigen Vorsprüngen aus. Im einfachsten Fall ist die gesamte Aufnahmevorrichtung 140 als Permanentmagnet ausgebildet, die das zumindest teilweise ferromagnetische Halterungselement anzieht. Alternativ können auch einzelne Permanentmagnete in die Aufnahmevorrichtung 140 und/oder in das Halterungselement integriert werden, die entsprechende ferromagnetische oder permanentmagnetische Teile gegenüber anziehen. Die Kugelschalenform der Vorsprünge und Vertiefungen sorgt für eine gut reproduzierbare Selbstzentrierung. Die Kraft des oder der Permanentmagnete ist praktisch fest, wodurch sich eine immer gleiche Haltekraft bei der gegenseitigen Anlage von Halterungselement und Aufnahmevorrichtung 140 ergibt. In der Aufnahmevorrichtung 140 ist hier eine Öffnung/Durchführung 142 für den Röntgenstrahl vorgesehen. In alternativen Bauformen kann sich die Aufnahmevorrichtung nur über einen Teil des Halterungselements erstrecken, der den Röntgenstrahlpfad nicht enthält (nicht dargestellt).

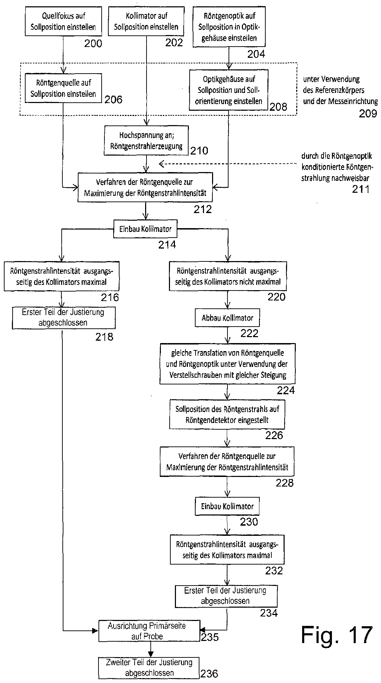

**Fig. 17** illustriert beispielhaft den Ablauf eine Variante des erfindungsgemäßen Verfahrens zur Justage der Primärseite eines erfindungsgemäßen Röntgendiffraktometers, wie es beispielsweise in Fig. 1 dargestellt ist.

Zu Beginn der Justage wird zunächst in einem Schritt 200 die Position des Quellfokus der Röntgenquelle im Gehäuse der Röntgenquelle auf einen vorgegebenen Fokussollwert relativ zum Gehäuse eingestellt, soweit noch erforderlich (bevorzugt ist die Röntgenquelle bereits herstellerseitig am gewünschten bzw. vorausgesetzten Fokussollwert fixiert). Alternativ kann auch die Relativposition des Quellfokus im Gehäuse vermessen werden, insbesondere relativ zu einer Sollposition, woraus sich eine Kalibrierkorrektur für die spätere Einstellung der Röntgenquelle auf deren Sollwert relativ zur Grundstruktur ergibt.

Weiterhin wird in einem Schritt 202 die Position des Kollimators auf einen Sollwert zur Grundstruktur eingestellt. Dabei wird typischerweise iterativ oder kontinuierlich die Position des Kollimators vermessen und verändert, bis der Sollwert erreicht ist. Hierbei werden in der Regel der Referenzkörper und eine oder mehrere Messeinrichtungen am Referenzkörper eingesetzt (Röntgenstrahlung ist nicht erforderlich). Alternativ, bei einem nicht verstellbaren Kollimator, wird dieser mit der erforderlichen Präzision montiert (typischerweise auf 50 µm genau oder besser, bevorzugt auf 20 µm genau oder besser).

Ebenso wird in einem Schritt 204 die Röntgenoptik in ihrem Gehäuse auf ihre vorgegebenen Röntgenoptiksollwerte relativ zum Gehäuse eingestellt, soweit noch erforderlich (bevorzugt ist die Röntgenoptik bereits herstellerseitig fest mit den gewünschten bzw. vorausgesetzten Röntgenoptiksollwerten fixiert).

In einem Schritt 206 wird die Position der Röntgenquelle (bzw. ihres Gehäuses) auf ihren Sollwert relativ zur Grundstruktur eingestellt. Dabei wird typischerweise iterativ oder laufend die Position relativ zur Grundstruktur vermessen bzw. bestimmt und verändert, bis der Sollwert erreicht ist. Ebenso wird in einem Schritt 208 die Position und die Orientierung der Röntgenoptik (bzw. ihres Gehäuses) auf ihre Sollwerte relativ zur Grundstruktur eingestellt. Dabei wird ebenfalls typischerweise iterativ oder laufend die Position und/oder die Orientierung relativ zur Grundstruktur vermessen bzw. bestimmt und verändert, bis die Sollwerte erreicht sind. Für die Schritte 206 und 208 wird der Referenzkörper an der Grundstruktur installiert, und eine oder mehrere Messeinrichtungen am Referenzkörper werden verwendet, vgl. Anmerkung 209. Danach kann der Referenzkörper wieder entfernt werden.

Die Schritte 206, 208 finden typischerweise nach den Schritten 200, 204 statt. Schritt 202 kann zusammen mit den Schritten 200, 204 oder auch (bevorzugt) zusammen mit den Schritten 206, 208 erfolgen; ebenso kann Schritt 202 auch bis nach dem Abschluss der Feinjustage der Röntgenquelle (vgl. dann Schritt 214) oder auch bis nach Abschluss der gemeinsamen Feineinstellung der Position der Röntgenquelle und der Position der Röntgenoptik und ggf. abermaligen Feinjustage der Röntgenquelle (vgl. dann Schritt 230) verschoben werden. In den Schritten 200, 202, 204, 206, 208 erfolgt die Einstellung des jeweiligen Sollwerts mit einer Genauigkeit von 50 µm oder besser, bevorzugt 20 µm oder besser (Positionen/Abstände), bzw. von 1 mrad oder besser, bevorzugt 0,5 mrad oder besser (Orientierungen/Winkel).

Nach den Schritten 206 und 208 befindet sich der Quellfokus der Röntgenquelle näherungsweise in einem Fokus (Brennpunkt) der Röntgenoptik, die typischerweise mit einem elliptisch gekrümmten Montelspiegel oder auch einem parabolisch gekrümmten Montelspiegel ausgebildet ist, weiterhin trifft der von der Röntgenquelle ausgehende Röntgenstrahl näherungsweise unter dem Bragg-Winkel auf der Röntgenoptik auf, und bevorzugt geht der von der Röntgenoptik konditionierte Röntgenstrahl näherungsweise mittig durch eine oder mehrere Kollimatoröffnungen des Kollimators.

Sodann wird in einem Schritt 210 die Hochspannung an der Röntgenquelle eingeschaltet, so dass von der Röntgenquelle ein Röntgenstrahl erzeugt wird. Aufgrund der vorangegangenen Justageschritte ist zu diesem Zeitpunkt bereits durch die Röntgenoptik konditionierte Röntgenstrahlung jenseits des Kollimators nachweisbar, vgl. Anmerkung 211. Falls dies nicht der Fall sein sollte, müssen Fehler aus den vorhergehenden Justageschritten beseitigt werden.

In einem Schritt 212 wird sodann durch iteratives Verfahren (Translation in x, y) der Röntgenquelle (bzw. deren Gehäuse) und Überprüfung der Intensität des konditionierten Röntgenstrahls hinter der Röntgenoptik eine Maximierung der Strahlintensität durchgeführt. Diese Feineinstellung der Position der Röntgenquelle wird in der vorgestellten Variante bei ausgebautem Kollimator vorgenommen. In der Regel ergeben sich bei der Feineinstellung nur Änderungen der Position von weniger als 200 µm, und meist weniger als 50 µm in x- und y-Richtung.

Anschließend kann der Kollimator in einem Schritt 214 wieder eingebaut werden. Oftmals ist zu diesem Zeitpunkt bereits eine maximale (oder zumindest für die geplante Anwendung ausreichend hohe) Röntgenstrahlintensität hinter dem Kollimator erreicht, vgl. Schritt 216. In diesem Fall kann der erste Teil der Justierung beendet werden, siehe Schritt 218.

Ist die Röntgenstrahlintensität hinter dem Kollimator noch nicht maximal (oder zumindest nicht ausreichend für die geplante Anwendung), vgl. Schritt 220, wird in der vorgestellten Variante der Kollimator in einem Schritt 222 wieder abgebaut und durch einen kalibrierten 2D-Detektor ersetzt (bevorzugt unter Nutzung einer Dreipunktaufnahme an der Grundstruktur, die wahlweise den Kollimator oder den 2D-Detektor halten kann), bei dem eine Sollposition der Kollimatoröffnung des (ersetzten) Kollimators markiert ist. Sodann wird eine gemeinsame Feineinstellung der Position von Röntgenquelle und der Position der Röntgenoptik vorgenommen, siehe Schritt 224. Hierfür werden iterativ die beiden Positionen im Gleichlauf verändert, das heißt in demselben Iterationsschritt werden die Position der Röntgenoptik und die Position der Röntgenquelle um gleiche Verstellwege in gleiche Richtungen verstellt, bis die der Röntgenstrahl sich an der markierten Sollposition auf der Detektorfläche des 2D-Detektors befindet. Beispielsweise werden die Röntgenoptik und die Röntgenquelle im selben Iterationsschritt jeweils um 10 µm in positive x-Richtung verfahren. Dafür wird an zugehörigen Verstellschrauben, die die gleiche Gewindesteigung besitzen, jeweils um gleiche Winkel verstellt (z.B. genau eine Umdrehung). In der Regel ergeben sich bei der gemeinsamen Feineinstellung nur Änderungen der Positionen von weniger als 150 µm, und meist weniger als 50 µm in x- und y-Richtung. Wenn sich schließlich der Röntgenstrahl an der markierten Sollposition befindet, vgl. Schritt 226, wäre die Röntgenstrahlintensität hinter dem Kollimator, wenn man ihn wieder anstelle des 2D-Detektors in den Strahlengang einbrächte, maximiert.

Alternativ zu Schritt 224 und 226 kann auch, im Falle eines verstellbaren Kollimators, eine Feineinstellung der Position des Kollimators bzw. wenigstens einer Lochblende des Kollimators erfolgen, um die Strahlintensität jenseits des Kollimators zu maximieren.

In der gezeigten Variante wird nach der gemeinsamen Feineinstellung 224 und Erreichen der Sollposition des Röntgenstrahls 226 noch eine weitere Feineinstellung der Position der Röntgenquelle 228 allein durchgeführt. Hierbei wird wiederum iterativ die Position der Röntgenquelle verändert, bis die konditionierte Röntgenstrahlintensität hinter der Röntgenoptik maximal ist. In der Regel ergeben sich bei dieser zweiten Feineinstellung nur Änderungen der Position von weniger als 20 µm, und meist weniger als 10 µm in x- und y-Richtung.

Anschließend wird der Kollimator eingebaut, vgl. Schritt 230, und es stellt sich eine maximale Röntgenstrahlintensität hinter dem Kollimator ein, vgl. Schritt 232. Falls gewünscht kann noch die aktuelle Position und Orientierung der Röntgenoptik und die aktuelle Position der Röntgenquelle, und ggf. auch die aktuelle Position des Kollimators bzw. wenigstens einer Lochblende notiert werden, um im Falle einer Dejustage schnell die gefundene Justierungseinstellung wiederfinden zu können. Damit ist der erste Teil des erfindungsgemäßen Justageverfahrens beendet, vgl. Schritt 234.

In der Praxis kann danach noch, soweit nötig, die Primärseite insgesamt genau auf die Probe ausgerichtet werden, vgl. Schritt 235, etwa durch Verfahren oder Verschwenken der Grundstruktur gegenüber einem Fußelement, das mit dem Goniometer verbunden ist. Danach ist der zweite Teil des erfindungsgemäßen Justierverfahrens beendet, vgl. Schritt 236.

Zusammenfassend beschreibt die vorliegende Erfindung ein Justierkonzept für die Primärseite eines Röntgendiffraktometers, insbesondere eines Einkristall-Röntgendiffraktometers mit Mikrofokus-Röntgenquelle, und ein zugehöriges Röntgendiffraktometer. Die Bauelemente der Primärseite (Röntgenquelle, Röntgenoptik und bevorzugt auch der Kollimator) werden einzeln gegenüber einer gemeinsamen Grundstruktur positioniert und orientiert, indem die Bauelemente an geometrisch vorbestimmte Sollpositionen bzw. in geometrisch bestimmte Sollorientierungen verbracht werden, bevorzugt mit einer Genauigkeit im Bereich von 50 µm oder besser, bevorzugt 20 µm oder besser an jeder Messstelle. Hierfür wird noch kein Röntgenstrahl benötigt, so dass diese Justageschritte einfach, schnell und sicher durchgeführt werden können. Für das Auffinden der Sollpositionen bzw. Sollorientierungen werden (in der Regel temporär angebrachte) Messeinrichtungen eingesetzt, die den Ort und/oder die Ausrichtung der Bauelemente oder Teilen davon relativ zur Grundstruktur bestimmen können, insbesondere Abstandsmessgeräte. Nach diesen Justageschritten ist ein Röntgenstrahl hinter dem Kollimator leicht und zuverlässig auffindbar, so dass weitere Justageschritte zur Intensitätsmaximierung (dann bei eingeschaltetem Röntgenstrahl) anschließend schnell erfolgen können. Ein typisches Röntgendiffraktometer für die Erfindung umfasst eine (stationäre) Mikrofokusröntgenröhre, einen Montel-Multilayer-Röntgenspiegel ("Montelspiegel"), einen Kollimator, eine Grundstruktur mit Kollimatorhalter, ein Goniometer mit mindestens einer motorisierten Rotationsachse, auf der sich ein Probenhalter befindet, der sich in Bezug auf die Rotationsachse(n) zentrieren lässt, und einen Flächendetektor zur Erfassung der von der Probe gebeugten Röntgenstrahlung, wobei der Kollimator durch Translationsverstellungen mit dem Kollimatorhalter (und damit mit der Grundstruktur) mechanisch verbunden ist (zur Feinjustierung seiner Position), wobei der Montelspiegel über Translations- und Rotationsverstellungen mit der Grundstruktur mechanisch verbunden ist (so dass sich der Montelspiegel entsprechend seinem idealen Braggwinkel auf mindestens 0,05 Grad und die ideale Position auf mindestens 0,1 mm Genauigkeit einstellen lässt), wobei die Röntgenröhre über Translationsverstellungen mit der Grundstruktur mechanisch verbunden ist (so dass sich die Röntgenröhre über die Translationen in den primären Fokus des Montelspiegels bringen lässt, und wobei die Grundstruktur über Translations- und/oder Rotationsverstellungen mit dem Goniometer mechanisch verbunden ist (so dass sich der Röntgenstrahl auf die Probe ausrichten lässt).

## Patentansprüche

1. Verfahren zur Justage der Primärseite (2) eines Röntgendiffraktometers (1), wobei die Primärseite (2) einen Kollimator (5), eine Röntgenoptik (4) und eine Röntgenquelle (3), insbesondere eine Röntgenröhre (15), umfasst,
wobei der Kollimator (5), die Röntgenoptik (4) und die Röntgenquelle (3) direkt oder indirekt an einer Grundstruktur (12) befestigt sind,
und wobei die Orientierung und Position der Röntgenoptik (4) und die Position der Röntgenquelle (3) relativ zur Grundstruktur (12) verstellt werden,
**dadurch gekennzeichnet,**
**dass** die Orientierung und Position der Röntgenoptik (4) und die Position der Röntgenquelle (3) relativ zur Grundstruktur (12) vermessen und auf vorgegebene Sollwerte eingestellt werden (206, 208), so dass bei den eingestellten Sollwerten ausgangsseitig des Kollimators (5) von der Röntgenquelle (3) ausgehende und durch die Röntgenoptik (4) konditionierte Röntgenstrahlung (6) nachweisbar ist (211),
und **dass** die Vermessung der Orientierung und Position der Röntgenoptik (4) und der Position der Röntgenquelle (3) relativ zur Grundstruktur (12) mit einer oder mehreren Messeinrichtungen indirekt gegenüber einem Referenzkörper (30) erfolgt, der in definierter Weise ausgebildet ist und in definierter Weise zur Grundstruktur (12) positioniert ist,
wobei die eine oder die mehreren Messeinrichtungen an dem Referenzkörper (30) angeordnet sind und/oder alle Messstellen (31a-31d, 32a-32d, 33a-33b) für die eine oder die mehreren Messeinrichtungen an dem Referenzkörper (30) ausgebildet sind, und wobei der Referenzkörper (13) lediglich zeitweilig während der Justage der Primärseite (2), nicht aber während eines laufenden Messbetriebs, an der Grundstruktur (12) angeordnet ist.

2. Verfahren nach Anspruch 1, **dadurch gekennzeichnet, dass** die Orientierung der Röntgenoptik (4) mit einer Genauigkeit von 1 mrad oder besser und die Positionen der Röntgenoptik (4) und der Röntgenquelle (3) mit einer Genauigkeit von 50 µm oder besser, bevorzugt 20 µm oder besser, vermessen und eingestellt werden (206, 208).

3. Verfahren nach Anspruch 1 oder 2, **dadurch gekennzeichnet, dass**
- die Orientierung und Position der Röntgenoptik (4) relativ zur Grundstruktur (12) und
- die Position der Röntgenquelle (3) relativ zur Grundstruktur (12) unabhängig voneinander eingestellt werden.

4. Verfahren nach einem der vorhergehenden Ansprüche, **dadurch gekennzeichnet, dass** die Position der Röntgenquelle (3) sowie die Position und Orientierung der Röntgenoptik (4) durch Abstandsmessungen vermessen werden.

5. Verfahren nach einem der Ansprüche 1 bis 4, **dadurch gekennzeichnet, dass** für die Justage der Primärseite (2) des Röntgendiffraktometers (1) die Position und Orientierung der Röntgenoptik (4) verstellt wird, indem die Position und die Orientierung eines Gehäuses (20) der Röntgenoptik (4), in dem die Röntgenoptik (4) angeordnet ist, insbesondere fest angeordnet ist, verstellt wird, und dass zur Bestimmung der Position und Orientierung der Röntgenoptik (4) relativ zur Grundstruktur (12) die Position und Orientierung des Gehäuses (20) der Röntgenoptik (4) vermessen wird.

6. Verfahren nach einem der Ansprüche 1 bis 4, **dadurch gekennzeichnet, dass** die Röntgenoptik (4) in einem Gehäuse (20) angeordnet ist, das zumindest teilweise aus optisch transparentem Material (65) gefertigt ist, und dass die Vermessung der Position und der Orientierung der Röntgenoptik (4) relativ zur Grundstruktur (12) durch das optisch transparente Material (65) hindurch erfolgt, insbesondere mittels Laserentfernungsmessung,
insbesondere wobei für die Justage der Primärseite (2) des Röntgendiffraktometers (1) die Position und die Orientierung der Röntgenoptik (4) im Gehäuse (20) der Röntgenoptik (4) verstellt wird.

7. Verfahren nach einem der vorhergehenden Ansprüche, **dadurch gekennzeichnet,**
**dass** die Position der Röntgenquelle (3) in zwei linear unabhängige Richtungen (x, y) senkrecht zur Strahlausbreitungsrichtung (z) relativ zur Grundstruktur (12) verstellt wird,
insbesondere wobei die Position der Röntgenquelle (3) durch zwei Abstandsmessungen vermessen wird,
und **dass** die Position der Röntgenoptik (4) in zwei linear unabhängigen Richtungen (x, y) senkrecht zur Strahlausbreitungsrichtung (z) und die Orientierung der Röntgenoptik (4) bezüglich zweier Achsen (A, B) senkrecht zur Strahlausbreitungsrichtung (z) relativ zur Grundstruktur (12) verstellt wird,
insbesondere wobei die Position und Orientierung der Röntgenoptik (4) durch vier Abstandsmessungen vermessen wird.

8. Verfahren nach einem der vorhergehenden Ansprüche, **dadurch gekennzeichnet, dass** weiterhin die Position wenigstens einer Kollimatoröffnung (135, 136) des Kollimators (5) relativ zur Grundstruktur (12) indirekt gegenüber einem Referenzkörper (30) vermessen und auf einen vorgegebenen Sollwert eingestellt wird (202), so dass bei den eingestellten Sollwerten ausgangsseitig des Kollimators (5) von der Röntgenquelle (3) ausgehende und durch die Röntgenoptik (4) konditionierte Röntgenstrahlung (6) nachweisbar ist (211).

9. Verfahren nach Anspruch 8, **dadurch gekennzeichnet, dass** die Position der wenigstens einen Kollimatoröffnung (135, 136) des Kollimators (5) relativ zur Grundstruktur (12) unabhängig von der Position der Röntgenquelle (3) und der Position und Orientierung der Röntgenoptik (4) eingestellt wird.

10. Verfahren nach einem der vorhergehenden Ansprüche, **dadurch gekennzeichnet, dass** nach Einstellung der vorgegebenen Sollwerte eine Feineinstellung der Position der Röntgenquelle (3) erfolgt, bei der eine Strahlintensität ausgangsseitig der Röntgenoptik (4) maximiert wird (212), insbesondere wobei für diese Feineinstellung der Position der Röntgenquelle (3) der Kollimator (5) aus dem Strahlengang des Röntgendiffraktometers (1) entfernt wird.

11. Verfahren nach einem der Ansprüche 1 bis 10, **dadurch gekennzeichnet, dass** nach Einstellung der vorgegebenen Sollwerte (206, 208) und ggf. Feineinstellung der Position der Röntgenquelle (3) (212) eine gemeinsame Feineinstellung der Position der Röntgenquelle (3) und der Position der Röntgenoptik (4) erfolgt, bei der eine Strahlintensität ausgangsseitig des Kollimators (5) maximiert wird, wobei zwischen Intensitätsmessungen die Röntgenoptik (4) und die Röntgenquelle (3) jeweils um gleiche Strecken in gleiche Richtungen verfahren werden (224).

12. Verfahren nach einem der Ansprüche 1 bis 10, **dadurch gekennzeichnet, dass** nach Einstellung der vorgegebenen Sollwerte (206, 208) und ggf. Feineinstellung der Position der Röntgenquelle (3) (212) eine Feineinstellung der Position wenigstens einer Kollimatoröffnung (135, 136) des Kollimators (5) erfolgt, bei der eine Strahlintensität ausgangsseitig des Kollimators (5) maximiert wird.

13. Verfahren nach einem der vorhergehenden Ansprüche, **dadurch gekennzeichnet, dass** vor dem Einstellen der vorgegebenen Sollwerte (206, 208) zunächst eine Position eines Quellfokus (17) der Röntgenquelle (3) relativ zu einem Gehäuse (14) der Röntgenquelle (3) bestimmt oder auf einen vorgegebenen Fokussollwert relativ zum Gehäuse (14) eingestellt wird (200),
und dass für die Justage der Primärseite (2) des Röntgendiffraktometers (1) die Position der Röntgenquelle (3) verstellt wird, indem die Position des Gehäuses (14) der Röntgenquelle (3) verstellt wird, und zur Bestimmung der Position der Röntgenquelle (3) relativ zur Grundstruktur (12) die Position des Gehäuses (14) der Röntgenquelle (3) vermessen wird.

14. Verfahren nach einem der vorhergehenden Ansprüche, **dadurch gekennzeichnet, dass** am Ende der Justage der Primärseite (2) die Orientierung und Position der Röntgenoptik (4) und die Position der Röntgenquelle (3) und ggf. auch die Position der wenigstens einen Kollimatoröffnung (135, 136) des Kollimators (5) relativ zur Grundstruktur (12) nochmals vermessen werden und die zugehörigen Messdaten notiert werden, und dass nach einer Dejustage eines oder mehrerer Bauelemente (3, 4, 5), insbesondere durch ein Erdbeben oder eine andere äußere Erschütterung des Röntgendiffraktometers (1), die Bauelemente (3, 4, 5) entsprechend der notierten Messdaten relativ zur Grundstruktur (12) eingestellt werden.

15. Verfahren nach einem der vorhergehenden Ansprüche, **dadurch gekennzeichnet, dass** die Primärseite (2) insgesamt auf eine Probe (7) ausgerichtet wird (235), indem die Grundstruktur (12) gegenüber einem Fußelement (13), das mit einem Goniometer (8) verbunden ist, verfahren oder verschwenkt wird,
insbesondere wobei das Fußelement (13) starr mit dem Goniometer (8) verbunden ist, und insbesondere wobei die Probe (7) auf dem Goniometer (8) angeordnet ist.

16. Röntgendiffraktometer (1),
wobei eine Primärseite (2) des Röntgendiffraktometers (1) einen Kollimator (5), eine Röntgenoptik (4) und eine Röntgenquelle (3), insbesondere eine Röntgenröhre (15), umfasst,
wobei der Kollimator (5), die Röntgenoptik (4) und die Röntgenquelle (3) direkt oder indirekt an einer Grundstruktur (12) befestigt sind,
und wobei die Orientierung und Position der Röntgenoptik (4) und die Position der Röntgenquelle (3) relativ zur Grundstruktur (12) durch Verstelleinrichtungen (41, 44, 48, 49; 51, 52) verstellbar sind,
**dadurch gekennzeichnet,**
**dass** das Röntgendiffraktometer (1) eine oder mehrere Messeinrichtungen umfasst, mit denen die Orientierung und Position der Röntgenoptik (4) und die Position der Röntgenquelle (3) relativ zur Grundstruktur (12) bestimmbar sind,
**dass** das Röntgendiffraktometer (1) einen Referenzkörper (30) umfasst, wobei der Referenzkörper (30) reversibel an der Grundstruktur (12) befestigt ist,
und **dass** die eine oder die mehreren Messeinrichtungen an dem Referenzkörper (30) angeordnet sind und/oder alle Messstellen (31a-31d, 32a-32b, 33a-33b) für die eine oder die mehreren Messeinrichtungen an dem Referenzkörper (30) ausgebildet sind, um die Primärseite (2) des Röntgendiffraktometers (1) zu justieren.

17. Röntgendiffraktometer (1) nach Anspruch 16, **dadurch gekennzeichnet, dass** die eine oder die mehreren Messeinrichtungen eine Messgenauigkeit für die Orientierung der Röntgenoptik (4) von 1 mrad oder besser und eine Messgenauigkeit für die Positionen der Röntgenoptik (4) und der Röntgenquelle (3) von 50 µm oder besser, bevorzugt 20 µm oder besser, aufweisen.

18. Röntgendiffraktometer (1) nach Anspruch 16 oder 17, **dadurch gekennzeichnet, dass** die eine oder die mehreren Messeinrichtungen ein mechanisches Abtastelement (34) und/oder ein Laserentfernungsmesselement (61) umfassen.

19. Röntgendiffraktometer (1) nach einem der Ansprüche 16 bis 18, **dadurch gekennzeichnet, dass** die Röntgenoptik (4) mit einem Montelspiegel (19) oder einem Goebelspiegel ausgebildet ist.

20. Röntgendiffraktometer (1) nach einem der Ansprüche 16 bis 19, **dadurch gekennzeichnet, dass** die Röntgenquelle (3) mit
- einer Mikrofokus-Röntgenröhre, insbesondere einer stationären Mikrofokus-Röntgenröhre,
- einer Drehanoden-Röntgenröhre oder
- einer Flüssigmetall-Röntgenröhre ausgebildet ist.

21. Röntgendiffraktometer (1) nach einem der Ansprüche 16 bis 20, **dadurch gekennzeichnet, dass** der Referenzkörper (30), an dem die eine oder die mehreren Messeinrichtungen angeordnet sind und/oder alle Messstellen (31a-31d, 32a-32b, 33a-33b) für die eine oder die mehreren Messeinrichtungen ausgebildet sind, als ein einziges, einstückiges Bauteil ausgebildet ist.

22. Röntgendiffraktometer (1) nach einem der Ansprüche 16 bis 21, **dadurch gekennzeichnet, dass** der Referenzkörper (30) an einer in Strahlausbreitungsrichtung (z) verlaufenden Führung (80), insbesondere Nut, auf die Grundstruktur (12) aufschiebbar und an der Grundstruktur (12) arretierbar ist, insbesondere mittels Feststellschrauben (87, 88), und dass ein Anschlagelement (86; 99), insbesondere am Referenzkörper (30) oder an der Grundstruktur (12) oder an einem Gehäuse (20) der Röntgenoptik (4) oder einer Haltevorrichtung (21) der Röntgenoptik (4), vorgesehen ist, mit dem eine definierte Position des Referenzkörpers (30) auf der Führung (80) aufgesucht werden kann.

23. Röntgendiffraktometer (1) nach Anspruch 22, **dadurch gekennzeichnet, dass** die Röntgenoptik (4) mittels einer Haltevorrichtung (21) an der Grundstruktur (12) befestigt ist,
dass ein Basiselement (40) der Haltevorrichtung (21) entlang einer in Strahlausbreitungsrichtung (z) verlaufenden Basisführung (90), insbesondere Nut, der Grundstruktur (12) verfahrbar und an der Grundstruktur (12) arretierbar ist, insbesondere wobei ein Endanschlag (97) und/oder eine Skala (98) für das Basiselement (40) ausgebildet ist, dass ein Zwischenelement (46) der Haltevorrichtung (21) gegenüber dem Basiselement (40) in zwei zueinander senkrechte Richtungen (x, y), die senkrecht zur Strahlausbreitungsrichtung (z) verlaufen, im Folgenden erste Richtung (x) und zweite Richtung (y) genannt, verstellbar ist, dass die Röntgenoptik (4) gegenüber dem Zwischenelement (46) um zwei zueinander senkrechte Achsen (A, B), die senkrecht zur Strahlausbreitungsrichtung (z) verlaufen, verkippbar ist,
insbesondere wobei die Röntgenoptik (4) von dem Zwischenelement (46) umgriffen ist,
und dass das Anschlagelement (99) des Referenzkörpers (30) entlang der ersten Richtung (x) auf das Zwischenelement (46) zu ausfahrbar ist, wobei das Zwischenelement (46) und das Anschlagelement (99) gegenseitige Anschlagflächen (102) parallel zur ersten und zweiten Richtung (x, y) ausbilden.

24. Röntgendiffraktometer (1) nach einem der Ansprüche 16 bis 23, **dadurch gekennzeichnet, dass** das Röntgendiffraktometer (1) ein Fußelement (13) aufweist, wobei eine Position und/oder Orientierung der Grundstruktur (12) gegenüber dem Fußelement (13) verstellbar ist, insbesondere wobei die Orientierung der Grundstruktur (12) entlang zweier zueinander senkrechter Achsen (C, D), die senkrecht zur Strahlausbreitungsrichtung (z) verlaufen, verstellbar ist.

25. Röntgendiffraktometer (1) nach einem der Ansprüche 16 bis 24, **dadurch gekennzeichnet, dass** der Kollimator (5), die Röntgenoptik (4) und die Röntgenquelle (3) unabhängig voneinander an der Grundstruktur (12) befestigt sind, und dass für die Röntgenoptik (4) und die Röntgenquelle (3) jeweils eigene Verstelleinrichtungen (41, 44, 48, 49; 51, 52) vorgesehen sind, so dass
- die Orientierung und Position der Röntgenoptik (4) relativ zur Grundstruktur (12)
- und die Position der Röntgenquelle (3) relativ zur Grundstruktur (12) unabhängig voneinander eingestellt werden können.

26. Röntgendiffraktometer (1) nach Anspruch 25, **dadurch gekennzeichnet, dass** die Röntgenoptik (4) und/oder die Röntgenquelle (3) und/oder der Kollimator (5) jeweils reversibel auf einer Zwischenhalterung (18a) befestigt sind, und dass jede Zwischenhalterung (18a) jeweils einzeln mittels einer eigenen Verstelleinrichtung (41, 44, 48, 49; 51, 52) gegenüber der Grundstruktur (12) verstellbar ist,
insbesondere wobei die Zwischenhalterung (18a) oder die Zwischenhalterungen (18a) als Klemmhalterungen (117) und/oder Magnethalterungen (137), bevorzugt Dreipunkt-Magnethalterungen, mit einer voreingestellten Klemmkraft oder Haltekraft ausgebildet sind.

27. Röntgendiffraktometer (1) nach einem der Ansprüche 16 bis 26, **dadurch gekennzeichnet, dass** die Verstelleinrichtungen (41, 44, 48, 49; 51, 52) zur Verstellung der Position der Röntgenquelle (3) und zur Verstellung der Position der Röntgenoptik (4) in einer jeweiligen Richtung als Verstellschrauben (42, 45, 53, 54) mit gleicher Ganghöhe ausgebildet sind.

## Claims

1. A method for adjusting the primary side (2) of an X-ray diffractometer (1),
wherein the primary side (2) comprises a collimator (5), an X-ray optics (4), and an X-ray source (3), in particular an X-ray tube (15),
wherein the collimator (5), the X-ray optics (4) and the X-ray source (3) are mounted directly or indirectly on a base structure (12),
and wherein the orientation and position of the X-ray optics (4) and the position of the X-ray source (3) are adjusted relative to the base structure (12),
**characterized in that**
the orientation and position of the X-ray optics (4) and the position of the X-ray source (3) relative to the base structure (12) are measured and set at predetermined target values (206, 208), so that with these set target values, X-ray radiation (6) emanating from the X-ray source (3) and conditioned by the X-ray optics (4) is detectable (211) at the output end of the collimator (5),
and that the measurement of the orientation and position of the X-ray optics (4) and of the position of the X-ray source (3) relative to the base structure (12) is performed with one or more measurement devices indirectly with respect to a reference body (30), which is designed in a defined manner and is positioned in a defined manner relative to the base structure (12),
wherein the one or more measurement devices are arranged on the reference body (30) and/or all measurement sites (31a-31d, 32a-32d, 33a-33b) for the one or the more measurement devices are formed on the reference body (30),
and wherein the reference body (13) is arranged on the base structure (12) only temporarily during adjustment of the primary side (2) but not during an ongoing measuring operation.

2. The method according to claim 1, **characterized in that** the orientation of the X-ray optics (4) is measured and set (206, 208) with an accuracy of 1 mrad or better, and the positions of the X-ray optics (4) and of the X-ray source (3) are measured and set (206, 208) with an accuracy of 50 µm or better, preferably 20 µm or better.

3. The method according to claim 1 or 2, **characterized in that**
- the orientation and position of the X-ray optics (4) relative to the base structure (12) and
- the position of the X-ray source (3) relative to the base structure (12) are set independently of one another.

4. The method according to any one of the preceding claims, **characterized in that** the position of the X-ray source (3) and the position and orientation of the X-ray optics (4) are measured by distance measurements.

5. The method according to any one of claims 1 to 4, **characterized in that** for adjusting the primary side (2) of the X-ray diffractometer (1), the position and orientation of the X-ray optics (4) are adjusted by adjusting the position and orientation of a housing (20) of the X-ray optics (4) in which the X-ray optics (4) is arranged, in particular being fixedly arranged, and to determine the position and orientation of the X-ray optics (4) relative to the base structure (12), the position and orientation of the housing (20) of the X-ray optics (4) are measured.

6. The method according to any one of claims 1 to 4, **characterized in that** the X-ray optics (4) is arranged in a housing (20) which is manufactured at least in part from optically transparent material (65), and the measurement of the position and the orientation of the X-ray optics (4) relative to the base structure (12) are performed through the optically transparent material (65), in particular by means of laser distance measurement, in particular wherein for adjusting the primary side (2) of the X-ray diffractometer (1), the position and the orientation of the X-ray optics (4) are adjusted in the housing (20) of the X-ray optics (4).

7. The method according to any one of the preceding claims, **characterized in that**
the position of the X-ray source (3) is adjusted in two linearly independent directions (x, y) perpendicular to the beam propagation direction (z) relative to the base structure (12),
in particular wherein the position of the X-ray source (3) is measured by means of two distance measurements,
and the position of the X-ray optics (4) is adjusted in two linearly independent directions (x, y) perpendicular to the beam propagation direction (z), and the orientation of the X-ray optics (4) is adjusted with respect to two axes (A, B) perpendicular to the beam propagation direction (z) relative to the base structure (12),
in particular wherein the position and orientation of the X-ray optics (4) are measured by means of four distance measurements.

8. The method according to any one of the preceding claims, **characterized in that** in addition, the position of at least one collimator aperture (135, 136) of the collimator (5) relative to the base structure (12) is measured indirectly with respect to a reference body (30) and is set (202) at a predetermined target value, so that with the target values preset, X-ray radiation (6) emitted by the X-ray source (3) and conditioned by the X-ray optics (4) is detectable (211) at the output end of the collimator (5).

9. The method according to claim 8, **characterized in that** the position of the at least one collimator aperture (135, 136) of the collimator (5) is adjusted relative to the base structure (12) independently of the position of the X-ray source (3) and the position and orientation of the X-ray optics (4).

10. The method according to any one of the preceding claims, **characterized in that** after adjusting the predetermined target values, a precision adjustment of the position of the X-ray source (3) is made in which the beam intensity at the output end of the X-ray optics (4) is maximized (212), in particular wherein the collimator (5) is removed from the beam path of the X-ray diffractometer (1) for this precision adjustment of the position of the X-ray source (3).

11. The method according to any one of claims 1 to 10, **characterized in that** after setting the predefined target values (206, 208) and optional precision adjustment of the position of the X-ray source (3) (212), a common precision adjustment of the position of the X-ray source (3) and the position of the X-ray optics (4) is performed in which the beam intensity at the output end of the collimator (5) is maximized, wherein the X-ray optics (4) and the X-ray source (3) are each moved by the same distances in the same directions (224) between intensity measurements.

12. The method according to any one of claims 1 to 10, **characterized in that** after setting the predefined target values (206, 208) and optional precision adjustment of the position of the X-ray source (3) (212), a precision adjustment of the position of at least one collimator aperture (135, 136) of the collimator (5) is performed in which the beam intensity at the output end of the collimator (5) is maximized.

13. The method according to any one of the preceding claims, **characterized in that** before setting the predefined target values (206, 208), first a position of a source focus (17) of the X-ray source (3) is determined relative to a housing (14) of the X-ray source (3) or is set (200) at a predefined focus target value relative to the housing (14),
and for adjusting the primary side (2) of the X-ray diffractometer (1), the position of the X-ray source (3) is adjusted by adjusting the position of the housing (14) of the X-ray source (3), and for determining the position of the X-ray source (3) relative to the base structure (12), the position of the housing (14) of the X-ray source (3) is measured.

14. The method according to any one of the preceding claims, **characterized in that**, after complete adjustment of the primary side (2), the orientation and position of the X-ray optics (4) and the position of the X-ray source (3) and optionally also the position of the at least one collimator aperture (135, 136) of the collimator (5) are measured again relative to the base structure (12) and the respective measured data are recorded, and after a misalignment of one or more components (3, 4, 5), in particular due to an earthquake or some other external vibration of the X-ray diffractometer (1), the components (3, 4, 5) are adjusted according to the recorded measured data relative to the base structure (12).

15. Method according to any one of the preceding claims, **characterized in that** the primary side (2) in total is directed (235) onto a sample (7) by moving or pivoting the base structure (12) with respect to a foot element (13) which is connected to a goniometer (8),
in particular wherein the foot element (13) is rigidly connected to the goniometer (8), and in particular wherein the sample (7) is arranged on the goniometer (8).

16. An X-ray diffractometer (1),
wherein a primary side (2) of the X-ray diffractometer (1) comprises a collimator (5), an X-ray optics (4) and an X-ray source (3), in particular an X-ray tube (15),
wherein the collimator (5), the X-ray optics (4) and the X-ray source (3) are mounted directly or indirectly on a base structure (12),
and wherein the orientation and position of the X-ray optics (4) and the position of the X-ray source (3) are adjustable relative to the base structure (12) by adjustment devices (41, 44, 48, 49; 51, 52), **characterized in that**
the X-ray diffractometer (1) comprises one or more measurement devices with which the orientation and position of the X-ray optics (4) and the position of the X-ray source (3) can be determined relative to the base structure (12),
the X-ray diffractometer (1) comprises a reference body (30), wherein the reference body (30) is reversibly mounted on the base structure (12), and the one or more measurement devices are arranged on the reference body (30) and/or all measurement sites (31a-31d, 32a-32b, 33a-33b) for the one or more measurement devices are formed on the reference body (30) in order to adjust the primary side (2) of the X-ray diffractometer (1).

17. The X-ray diffractometer (1) according to claim 16, **characterized in that** the one or more measurement devices have a measurement accuracy for the orientation of the X-ray optics (4) of 1 mrad or better and have a measurement accuracy for the positions of the X-ray optics (4) and of the X-ray source (3) of 50 µm or better, preferably 20 µm or better.

18. The X-ray diffractometer (1) according to claim 16 or 17, **characterized in that** the one or more measurement devices comprise a mechanical scanning element (34) and/or a laser distance measurement element (61).

19. The X-ray diffractometer (1) according to any one of claims 16 to 18, **characterized in that** the X-ray optics (4) is designed with a Montel mirror (19) or a Goebel mirror.

20. The X-ray diffractometer (1) according to any one of claims 16 to 19, **characterized in that** the X-ray source (3) is designed with
- a microfocus X-ray tube, in particular a stationary microfocus X-ray tube,
- a rotary anode X-ray tube or
- a liquid metal X-ray tube.

21. The X-ray diffractometer (1) according to any one of claims 16 to 20, **characterized in that** the reference body (30), on which the one or more measurement devices are arranged and/or on which all measurement sites (31a-31d, 32a-32b, 33a-33b) for the one or more measurement devices are formed, is designed as one single one-piece component.

22. The X-ray diffractometer (1) according to any one of claims 16 to 21, **characterized in that** the reference body (30) can be pushed onto a guide (80), in particular a groove, on the base structure (12), with the guide (80) running in the beam propagation direction (z), and wherein the reference body (30) can be locked on the base structure (12), in particular by means of locking screws (87, 88),
and a stop element (86; 99) is provided, in particular on the reference body (30) or on the base structure (12) or on a housing (20) of the X-ray optics (4) or a holding device (21) of the X-ray optics (4), with which a defined position of the reference body (30) on the guide (80) can be sought.

23. The X-ray diffractometer (1) according to claim 22, **characterized in that** the X-ray optics (4) is mounted on the base structure (12) by means of a holding device (21),
a base element (40) of the holding device (21) can be moved along a base guide (90), in particular a groove, of the base structure (12), with the base guide (90) running in the beam propagation direction (z), and wherein the base element (40) can be locked on the base structure (12), in particular wherein an end stop (97) and/or a scale (98) is/are formed for the base element (40),
an intermediate element (46) of the holding device (21) is adjustable with respect to the base element (40) in two mutually perpendicular directions (x, y), which run perpendicular to the beam propagation direction (z), hereinafter referred to as the first direction (x) and the second direction (y), the X-ray optics (4) can be tilted relative to the intermediate element (46) about two mutually perpendicular axes (A, B), which run perpendicular to the beam propagation direction (z),
in particular wherein the X-ray optics (4) is encompassed by the intermediate element (46),
and the stop element (99) of the reference body (30) can be extracted toward the intermediate element (46) along the first direction (x), wherein the intermediate element (46) and the stop element (99) form mutual stop faces (102) parallel to the first and second direction (x, y).

24. The X-ray diffractometer (1) according to any one of claims 16 to 23, **characterized in that** the X-ray diffractometer (1) has a foot element (13), wherein a position and/or orientation of the base structure (12) is adjustable with respect to the foot element (13),
in particular wherein the orientation of the base structure (12) is adjustable along two mutually perpendicular axes (C, D) that are perpendicular to the beam propagation direction (z).

25. The X-ray diffractometer (1) according to any one of claims 16 to 24, **characterized in that** the collimator (5), the X-ray optics (4) and the X-ray source (3) are mounted independently of one another on the base structure (12), and a separate adjusting devices (41, 44, 48, 49; 51, 52) are provided for each of the X-ray optics (4) and the X-ray source (3), so that
- the orientation and position of the X-ray optics (4) relative to the base structure (12)
- and the position of the X-ray source (3) relative to the base structure (12) can be adjusted independently of one another.

26. The X-ray diffractometer (1) according to claim 25, **characterized in that** the X-ray optics (4) and/or the X-ray source (3) and/or the collimator (5) is/are each mounted reversibly on an intermediate holder (18a), and each intermediate holder (18a) is adjustable individually with respect to the base structure (12) by means of a separate adjusting device (41, 44, 48, 49; 51, 52), in particular wherein the intermediate holder (18a) or the intermediate holders (18a) are designed as clamping holders (117) and/or magnetic holders (137), preferably three-point magnetic holders, with a predefined clamping force or holding force.

27. The X-ray diffractometer (1) according to any one of claims 16 to 26, **characterized in that** the adjusting devices (41, 44, 48, 49; 51, 52) for adjusting the position of the X-ray source (3) and for adjusting the position of the X-ray optics (4) are each designed as adjusting screws (42, 45, 53, 54) having the same pitch height in a respective direction.

## Revendications

1. Procédé de réglage du côté primaire (2) d'un diffractomètre à rayons X (1), dans lequel le côté primaire (2) comprend un collimateur (5), une optique à rayons X (4) et une source de rayons X (3), en particulier un tube à rayons X (15),
dans lequel le collimateur (5), l'optique à rayons X (4) et la source de rayons X (3) sont fixés directement ou indirectement à une structure de base (12),
et dans lequel on règle l'orientation et la position de l'optique à rayons X (4) et la position de la source de rayons X (3) par rapport à la structure de base (12), **caractérisé en ce**
**que** l'orientation et la position de l'optique à rayons X (4) et la position de la source de rayons X (3) par rapport à la structure de base (12) sont mesurées et réglées (206, 208) à des valeurs de consigne prédéfinies, de sorte que, aux valeurs de consigne réglées, un rayonnement X (6) provenant de la source de rayons X (3) et conditionné par l'optique à rayons X (4) peut être détecté (211) du côté sortie du collimateur (5),
et **que** la mesure de l'orientation et de la position de l'optique à rayons X (4) et de la position de la source de rayons X (3) par rapport à la structure de base (12) est effectuée indirectement avec un ou plusieurs moyens de mesure par rapport à un corps de référence (30) qui est conçu de manière définie et est positionné de manière définie par rapport à la structure de base (12),
dans lequel lesdits un ou plusieurs moyens de mesure sont disposés sur le corps de référence (30) et/ou tous les points de mesure (31a-31d, 32a-32d, 33a-33b) pour lesdits un ou plusieurs moyens de mesure sont formés sur le corps de référence (30),
et dans lequel le corps de référence (13) n'est disposé sur la structure de base (12) que temporairement pendant le réglage du côté primaire (2), mais pas pendant un mode de mesure en cours.

2. Procédé selon la revendication 1, **caractérisé en ce que** l'orientation de l'optique à rayons X (4) est mesurée et réglée (206, 208) avec une précision de 1 mrad ou mieux et les positions de l'optique à rayons X (4) et de la source de rayons X (3) sont mesurées et réglées (206, 208) avec une précision de 50 µm ou mieux, de préférence de 20 µm ou mieux.

3. Procédé selon la revendication 1 ou 2, **caractérisé en ce que**
- l'orientation et la position de l'optique à rayons X (4) par rapport à la structure de base (12) et
- la position de la source de rayons X (3) par rapport à la structure de base (12) sont réglées indépendamment l'une de l'autre.

4. Procédé selon l'une des revendications précédentes, **caractérisé en ce que** la position de la source de rayons X (3) ainsi que la position et l'orientation de l'optique à rayons X (4) sont mesurées par des mesures de distance.

5. Procédé selon l'une des revendications 1 à 4, **caractérisé en ce que** pour le réglage du côté primaire (2) du diffractomètre à rayons X (1), on règle la position et l'orientation de l'optique à rayons X (4) en réglant la position et l'orientation d'un boîtier (20) de l'optique à rayons X (4) dans lequel l'optique à rayons X (4) est disposée, en particulier de manière fixe, et que pour déterminer la position et l'orientation de l'optique à rayons X (4) par rapport à la structure de base (12), on mesure la position et l'orientation du boîtier (20) de l'optique à rayons X (4).

6. Procédé selon l'une des revendications 1 à 4, **caractérisé en ce que** l'optique à rayons X (4) est disposée dans un boîtier (20) qui est au moins partiellement fabriqué dans un matériau optiquement transparent (65), et que la mesure de la position et de l'orientation de l'optique à rayons X (4) par rapport à la structure de base (12) est effectuée à travers le matériau optiquement transparent (65), en particulier au moyen d'une mesure de distance par laser,
en particulier dans lequel, pour le réglage du côté primaire (2) du diffractomètre à rayons X (1), on règle la position et l'orientation de l'optique à rayons X (4) dans le boîtier (20) de l'optique à rayons X (4).

7. Procédé selon l'une des revendications précédentes, **caractérisé en ce**
**que** la position de la source de rayons X (3) par rapport à la structure de base (12) est réglée dans deux directions (x, y) linéairement indépendantes, perpendiculaires à la direction de propagation du faisceau (z),
en particulier dans lequel la position de la source de rayons X (3) est mesurée par deux mesures de distance,
et **que** la position de l'optique à rayons X (4) par rapport à la structure de base (12) est réglée dans deux directions (x, y) linéairement indépendantes, perpendiculaires à la direction de propagation du faisceau (z) et que l'orientation de l'optique à rayons X (4) par rapport à la structure de base (12) est réglée par rapport à deux axes (A, B) perpendiculaires à la direction de propagation du faisceau (z),
en particulier dans lequel la position et l'orientation de l'optique à rayons X (4) sont mesurées par quatre mesures de distance.

8. Procédé selon l'une des revendications précédentes, **caractérisé en ce qu'**en outre, la position d'au moins une ouverture de collimateur (135, 136) du collimateur (5) par rapport à la structure de base (12) est mesurée indirectement par rapport à un corps de référence (30) et réglée (202) à une valeur de consigne prédéfinie, de sorte que, aux valeurs de consigne réglées, un rayonnement X (6) provenant de la source de rayons X (3) et conditionné par l'optique à rayons X (4) peut être détecté (211) du côté sortie du collimateur (5).

9. Procédé selon la revendication 8, **caractérisé en ce que** la position de ladite au moins une ouverture de collimateur (135, 136) du collimateur (5) par rapport à la structure de base (12) est réglée indépendamment de la position de la source de rayons X (3) et de la position et de l'orientation de l'optique à rayons X (4).

10. Procédé selon l'une des revendications précédentes, **caractérisé en ce qu'**après avoir réglé les valeurs de consigne prédéfinies, on effectue un réglage fin de la position de la source de rayons X (3), auquel une intensité de faisceau du côté sortie de l'optique à rayons X (4) est maximisée (212), en particulier dans lequel, pour ce réglage fin de la position de la source de rayons X (3), le collimateur (5) est retiré du chemin optique du diffractomètre à rayons X (1).

11. Procédé selon l'une des revendications 1 à 10, **caractérisé en ce qu'**après avoir réglé les valeurs de consigne prédéfinies (206, 208) et, le cas échéant, réglé finement la position de la source de rayons X (3) (212), on effectue un réglage fin commun de la position de la source de rayons X (3) et de la position de l'optique à rayons X (4), auquel une intensité de faisceau du côté sortie du collimateur (5) est maximisée, dans lequel l'optique à rayons X (4) et la source de rayons X (3) sont déplacées (224) chaque fois de distances égales dans les mêmes directions entre les mesures d'intensité.

12. Procédé selon l'une des revendications 1 à 10, **caractérisé en ce qu'**après avoir réglé les valeurs de consigne prédéfinies (206, 208) et, le cas échéant, réglé finement la position de la source de rayons X (3) (212), on effectue un réglage fin de la position d'au moins une ouverture de collimateur (135, 136) du collimateur (5), auquel une intensité de faisceau du côté sortie du collimateur (5) est maximisée.

13. Procédé selon l'une des revendications précédentes, **caractérisé en ce qu'**avant de régler les valeurs de consigne prédéfinies (206, 208), on détermine d'abord une position d'un foyer de source (17) de la source de rayons X (3) par rapport à un boîtier (14) de la source de rayons X (3) ou on règle celle-ci (200) à une valeur de consigne de foyer prédéfinie par rapport au boîtier (14),
et que, pour le réglage du côté primaire (2) du diffractomètre à rayons X (1), on règle la position de la source de rayons X (3) en réglant la position du boîtier (14) de la source de rayons X (3), et pour déterminer la position de la source de rayons X (3) par rapport à la structure de base (12), on mesure la position du boîtier (14) de la source de rayons X (3).

14. Procédé selon l'une des revendications précédentes, **caractérisé en ce qu'**à la fin du réglage du côté primaire (2), on mesure à nouveau l'orientation et la position de l'optique à rayons X (4) et la position de la source de rayons X (3) et, le cas échéant, aussi la position de ladite au moins une ouverture de collimateur (135, 136) du collimateur (5) par rapport à la structure de base (12) et on note les données de mesure correspondantes, et qu'après un déréglage d'un ou de plusieurs composants (3, 4, 5), en particulier dû à un tremblement de terre ou à un autre choc extérieur sur le diffractomètre à rayons X (1), les composants (3, 4, 5) sont réglés par rapport à la structure de base (12) selon les données de mesure notées.

15. Procédé selon l'une des revendications précédentes, **caractérisé en ce que** le côté primaire (2) est orienté (235) dans son ensemble vers un échantillon (7) en déplaçant ou faisant pivoter la structure de base (12) par rapport à un élément de pied (13) qui est relié à un goniomètre (8),
en particulier dans lequel l'élément de pied (13) est relié de manière rigide au goniomètre (8), et en particulier dans lequel l'échantillon (7) est disposé sur le goniomètre (8).

16. Diffractomètre à rayons X (1),
dans lequel un côté primaire (2) du diffractomètre à rayons X (1) comprend un collimateur (5), une optique à rayons X (4) et une source de rayons X (3), en particulier un tube à rayons X (15),
dans lequel le collimateur (5), l'optique à rayons X (4) et la source de rayons X (3) sont fixés directement ou indirectement à une structure de base (12),
et dans lequel l'orientation et la position de l'optique à rayons X (4) et la position de la source de rayons X (3) par rapport à la structure de base (12) sont réglables par des moyens de réglage (41, 44, 48, 49 ; 51, 52),
**caractérisé en ce**
**que** le diffractomètre à rayons X (1) comprend un ou plusieurs moyens de mesure qui permettent de déterminer l'orientation et la position de l'optique à rayons X (4) et la position de la source de rayons X (3) par rapport à la structure de base (12),
**que** le diffractomètre à rayons X (1) comprend un corps de référence (30), lequel corps de référence (30) est fixé de manière réversible à la structure de base (12), et que lesdits un ou plusieurs moyens de mesure sont disposés sur le corps de référence (30) et/ou que tous les points de mesure (31a-31d, 32a-32b, 33a-33b) pour lesdits un ou plusieurs moyens de mesure sont formés sur le corps de référence (30), pour régler le côté primaire (2) du diffractomètre à rayons X (1).

17. Diffractomètre à rayons X (1) selon la revendication 16, **caractérisé en ce que** lesdits un ou plusieurs moyens de mesure présentent une précision de mesure pour l'orientation de l'optique à rayons X (4) de 1 mrad ou mieux et une précision de mesure pour les positions de l'optique à rayons X (4) et de la source de rayons X (3) de 50 µm ou mieux, de préférence de 20 µm ou mieux.

18. Diffractomètre à rayons X (1) selon la revendication 16 ou 17, **caractérisé en ce que** lesdits un ou plusieurs moyens de mesure comprennent un élément de palpage mécanique (34) et/ou un élément de mesure de distance par laser (61).

19. Diffractomètre à rayons X (1) selon l'une des revendications 16 à 18, **caractérisé en ce que** l'optique à rayons X (4) est formée d'un miroir Montel (19) ou d'un miroir de Goebel.

20. Diffractomètre à rayons X (1) selon l'une des revendications 16 à 19, **caractérisé en ce que** la source de rayons X (3) est réalisée avec
- un tube à rayons X à microfoyer, en particulier un tube à rayons X à microfoyer fixe,
- un tube à rayons X à anode tournante ou
- un tube à rayons X à métal liquide.

21. Diffractomètre à rayons X (1) selon l'une des revendications 16 à 20, **caractérisé en ce que** le corps de référence (30) sur lequel sont disposés lesdits un ou plusieurs moyens de mesure et/ou tous les points de mesure (31a-31d, 32a-32b, 33a-33b) pour lesdits un ou plusieurs moyens de mesure est réalisé sous la forme d'un élément unique d'une seule pièce.

22. Diffractomètre à rayons X (1) selon l'une des revendications 16 à 21, **caractérisé en ce que** le corps de référence (30) peut être glissé sur la structure de base (12) sur un guide (80), en particulier une rainure, s'étendant dans la direction de propagation du faisceau (z) et peut être arrêté sur la structure de base (12), en particulier au moyen de vis de blocage (87, 88),
et qu'un élément de butée (86 ; 99) est prévu, en particulier sur le corps de référence (30) ou sur la structure de base (12) ou sur un boîtier (20) de l'optique à rayons X (4) ou un dispositif de maintien (21) de l'optique à rayons X (4), avec lequel on peut retrouver une position définie du corps de référence (30) sur le guide (80).

23. Diffractomètre à rayons X (1) selon la revendication 22, **caractérisé en ce que** l'optique à rayons X (4) est fixée à la structure de base (12) au moyen d'un dispositif de maintien (21),
qu'un élément de base (40) du dispositif de maintien (21) peut être déplacé le long d'un guide de base (90), en particulier d'une rainure, s'étendant dans la direction de propagation du faisceau (z), de la structure de base (12), et arrêté sur la structure de base (12), en particulier dans lequel une butée (97) et/ou une échelle (98) est formée pour l'élément de base (40),
qu'un élément intermédiaire (46) du dispositif de retenue (21) est déplaçable par rapport à l'élément de base (40) dans deux directions (x, y) perpendiculaires l'une à l'autre, qui s'étendent perpendiculairement à la direction de propagation du faisceau (z) et qui sont désignées ci-après par première direction (x) et deuxième direction (y),
que l'optique à rayons X (4) peut être basculée par rapport à l'élément (46) intermédiaire autour de deux axes (A, B) perpendiculaires l'un à l'autre et s'étendant perpendiculairement à la direction de propagation du faisceau (z),
en particulier dans lequel l'optique à rayons X (4) est entourée par l'élément intermédiaire (46),
et que l'élément de butée (99) du corps de référence (30) peut être déplacé le long de la première direction (x) vers l'élément intermédiaire (46), l'élément intermédiaire (46) et l'élément de butée (99) formant des surfaces de butée mutuelles (102) parallèlement à la première et à la deuxième direction (x, y).

24. Diffractomètre à rayons X (1) selon l'une des revendications 16 à 23, **caractérisé en ce que** le diffractomètre à rayons X (1) présente un élément de pied (13), dans lequel une position et/ou une orientation de la structure de base (12) par rapport à l'élément de pied (13) est réglable, en particulier dans lequel l'orientation de la structure de base (12) est réglable le long de deux axes (C, D) perpendiculaires l'un à l'autre qui s'étendent perpendiculairement à la direction de propagation du faisceau (z).

25. Diffractomètre à rayons X (1) selon l'une des revendications 16 à 24, **caractérisé en ce que** le collimateur (5), l'optique à rayons X (4) et la source de rayons X (3) sont fixés sur la structure de base (12) indépendamment les uns des autres, et que des moyens de réglage séparés (41, 44, 48, 49 ; 51, 52) sont prévus pour l'optique à rayons X (4) et pour la source de rayons X (3), de sorte que
- l'orientation et la position de l'optique à rayons X (4) par rapport à la structure de base (12)
- et la position de la source de rayons X (3) par rapport à la structure de base (12) peuvent être réglées indépendamment l'une de l'autre.

26. Diffractomètre à rayons X (1) selon la revendication 25, **caractérisé en ce que** l'optique à rayons X (4) et/ou la source de rayons X (3) et/ou le collimateur (5) sont fixés chacun de manière réversible sur un support intermédiaire (18a), et que chaque support intermédiaire (18a) est réglable individuellement au moyen de son propre moyen de réglage (41, 44, 48, 49 ; 51, 52) par rapport à la structure de base (12), en particulier dans lequel le support intermédiaire (18a) ou les supports intermédiaires (18a) sont réalisés sous la forme de supports de serrage (117) et/ou de supports magnétiques (137), de préférence de supports magnétiques à trois points, avec une force de serrage ou une force de maintien préréglée.

27. Diffractomètre à rayons X (1) selon l'une des revendications 16 à 26, **caractérisé en ce que** les moyens de réglage (41, 44, 48, 49 ; 51, 52) pour le réglage de la position de la source de rayons X (3) et pour le réglage de la position de l'optique à rayons X (4) dans une direction respective sont réalisés sous la forme de vis de réglage (42, 45, 53, 54) de pas identique.
